# EUROPEAN PATENT SPECIFICATION

(11) **EP 0 297 461 B1**
(45) Date of publication and mention of the grant of the patent: **07.09.1994**
(21) Application number: 88110133.1
(22) Date of filing: 24.06.1988
(51) Int. Cl.: G11B 20/02, G11B 5/027, G11B 23/00, H03G 7/00, H03G 9/02, G11B 20/00

(54) **Amplitude compressing/Expanding circuit**
Schaltung zur Kompression/Expansion der Dynamik eines Signals
Circuit de compression/expansion d'amplitude

(30) Priority: 27.06.1987 JP 160525/87; 30.06.1987 JP 163611/87
(43) Date of publication of application: 04.01.1989
(73) Proprietor: SONY CORPORATION, Tokyo 141 (JP)
(72) Inventor: Akagiri, Kenzo, Shinagawa-ku Tokyo (JP); Sato, Tomoko, Shinagawa-ku Tokyo (JP)
(74) Representative: TER MEER STEINMEISTER & PARTNER GbR

(56) References cited:
- EP-A- 0 127 988
- DD-A- 225 809
- GB-A- 2 083 988
- JOURNAL OF THE AUDIO ENGINEERING SOCIETY, vol. 35, no. 3, March 1987, New York, US; pages 99-118, R. DOLBY: "The spectral recording process"
- PROCEEDINGS OF ICASSP 86, April 7-11, 1986 Tokyo, JP; Paper 8.5, vol. 1, pages 401-404; KANEKO et al.: "A 50 ns floating-point signal processor VLSI"

## Description

### BACKGROUND OF THE INVENTION

### Field of the Invention

The present invention relates to an amplitude compressing/expanding circuit which is suitable for use in signal processing circuits of electronic appliances such as a compact disc (CD) player and a tape recorder.

### Prior Art

It has so far been practiced in digital audio signal reproducing apparatus such as CD players and digital audio tape recorders (DAT) that an audio signal recorded, after being digitized, on a recording medium is reproduced and thereafter demodulated into a corresponding analog signal, whereby, a high-quality audio signal with little noise over a wide dynamic range is obtained.

There is however a problem that an audio signal obtained from such digital audio signal reproducing apparatus has an unwanted wide dynamic range when, for example, it is to be recorded by a conventional analog type tape recorder.

That is, because of its unnecessary wide dynamic range, when the reproduced analog signal is recorded by an analog tape recorder, the signal waveform of this audio signal is produced distortion at its higher signal level portion or its SN (signal-to-noise) ratio suffers deterioration, conversely, at its lower signal level portion.

Further, in the case where a CD player or the like is played back where there is background noise, such as within an automobile, there arises another problem that the signal portion at the lower signal level is lost in the background noise and becomes inaudible, or, conversely, the signal portion at the higher signal level produces excessively large volume of sound.

To solve such conventional problems, one of better solutions is to reduce the dynamic range of the audio signal obtained from the digital audio signal reproducing apparatus.

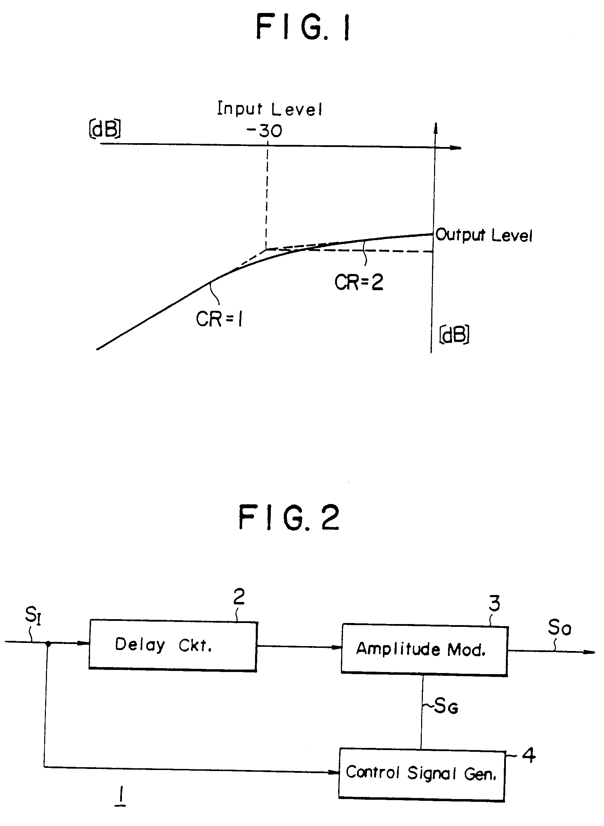

That is, as shown in Fig. 1, in an input signal constructed of an audio signal converted into an analog signal, the input signal at the level lower than -30 dB of the peak level may be output as an output signal whose signal level varies proportionally to the variation in the signal level of the input signal with a constant of proportion of 1.

On the other hand, the input signal in the range higher than -30 dB may be output such that it varies proportionally to the variation in the signal level of the input signal with a constant of proportion of, for example, 1/2.

By so doing, an input-output characteristic having the ratios of amplitude compression CR of values 1 and 2 in their respective ranges on both sides of the point at -30 dB (hereinafter this point will be referred to as a threshold point, or level) is obtained, and thus, the dynamic range of the audio signal as a whole can correspondingly be made narrower.

To obtain such an amplitude compressing and expanding effect, there is a prior art method using an amplitude compressing/expanding circuit of the structure as shown in Fig. 2.

That is, an input signal 8₁ is input to an amplitude modulation circuit 3 through a delay circuit 2 and it is also input to a control signal generator circuit 4.

The control signal generator circuit 4 detects the signal level of the input signal and, based upon the result of the detection, outputs a control signal S_{G}, of which signal level changes in accordance with the signal level of the input signal 8₁, to the amplitude modulation circuit 3.

The amplitude modulation circuit 3 is constructed of a multiplier circuit, VCA (voltage controlled amplifier), or the like and, by having the input signal 8₁ amplitude-modulated by the control signal S_{G}, provides an output signal So whose signal level is corresponding to the input signal Sₗ and changed according to the signal level of the control signal So.

It should be noted that the delay circuit 2 is provided so that no overshoot may occur in the output signal So.

Now, representing the amplitude of the input signal Sₗ by "x" and the amplitude of the output signal So by "y", the amplitude compression ratio CR can be expressed as:

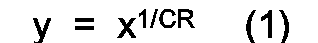

Therefore, in the control signal generator circuit 4, the amplitude y of the output signal So of which amplitude compression ratio CR applied to the amplitude x of the input signal Sₗ below the threshold point is a value of 1 is expressed as

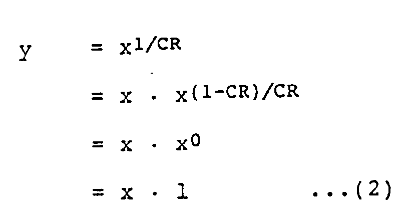

Therefore, corresponding to the coefficient 1 of the right side, by outputting the control signal S_{G} so that the gain "g" in the amplitude modulation circuit 3 may become value 1 as expressed by
g = 1, (3)

the characteristic providing the amplitude compression ratio CR of value 1 in the region below the threshold point can be obtained.

In contrast thereto, in the case where the output signal So, of which the amplitude compression ratio CR applied to the amplitude x of the input signal 8₁ in the range above the threshold point is of a value of 2, is to be obtained, the amplitude "y" of the output signal So and the gain "g" in the amplitude modulation circuit 3 are given by

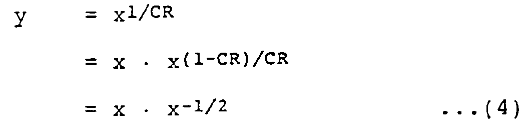

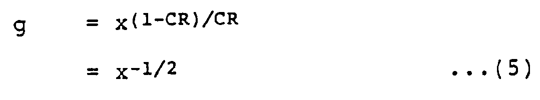

Therefore, by outputting the control signal S_{G} so that the gain g in the amplitude modulation circuit 3 may become x- ^{½}, an input/output characteristic providing the amplitude compression ratio CR of the value of 2 in the range above the threshold point can be obtained.

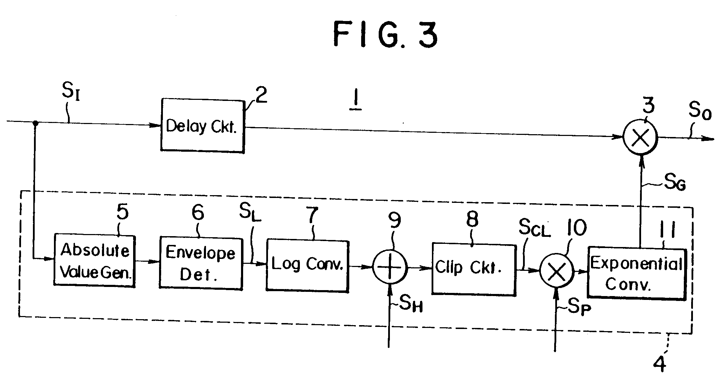

As a concrete example, the control signal generator circuit 4 may be structured as shown in Fig. 3. That is, the input signal Sₗ is input through an absolute value circuit 5 to an envelope detector circuit 6 and thereby a detection signal S_{L} proportional to the signal level of the input signal Sₗ is obtained, and this signal is then subjected to logarithmic conversion in a logarithmic converter circuit 7 and output to an adder circuit 9.

A clipping circuit 8 receives a summation signal of the logarithmically-converted detection signal S_{L} and a threshold point signal S_{H} provided through an adder circuit 9, and clips the summation signal below a value of 0 and output the thus obtained clipped signal S_{CL} to a multiplier circuit 10.

Thus, setting the threshold point signal S_{H} to a predetermined value enables a clipped signal S_{CL} to be obtained, of which signal levels varies with respect to both sides of the signal level of the input signal Sₗ to be determined by the threshold point signal S_{H}.

The multiplier circuit 10 receives both the clipped signal S_{CL} and a compression ratio controlling signal Sp and outputs a product signal thereof to the amplitude modulation circuit 3 through an exponential converter circuit 11.

Here, if the signal level of the input signal Sₗ at the threshold point (-30 dB in the present case) is expressed by "Y" with respect to the signal level, represented by H, of the output signal output from the logarithmic converter circuit 7 when the input signal Sₗ is at its peak level. Then if the threshold point signal S_{H} is expressed as 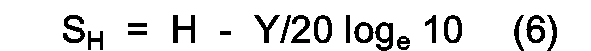 accordingly, a clipped signal S_{CL} whose signal level varies with the signal level of the input signal Sₗ only when the signal level of the input signal Sₗ is larger than the signal level at the threshold point can be obtained.

As a result, in the range below the threshold point, the clipped signal S_{CL} which has been clipped at the value of 0 through the clipper circuit 8 is obtained, and as a consequence, a control signal S_{G} of the value of 1 corresponding to the value of 0 is output through the exponential converter circuit 11.

Consequently, the gain of the multiplier circuit 3 is limited to 1 and thereby, the output signal So of which amplitude compression ratio CR is equal to the value of 1 as shown in equation (2) is obtained, and thus, the input/output characteristic producing the amplitude compression ratio CR of the value of 1 is obtained.

On the other hand, in the range above the threshold point, it will be satisfied if the gain of the multiplier circuit 3 is arranged to become x^{- ½} as indicated in equation (5).

That is, the below-mentioned control signal S_{G} at the signal level expressed as
G _{= x}(I - CR)/CR (₇)

may be output with respect to the input signal S.

More particularly, if the compression ratio controlling signal Sp is supplied to the multiplier circuit 10 so that the gain therein may become the value expressed as
Ap = - (CR - 1)/CR = - 1/2 (8)

an output signal So whose amplitude is compressed by the compression ratio CR (CR = 2 in the present case) in the range above the threshold point can be obtained.

Thus, an amplitude compressing/expanding circuit 1 of such an input/output characteristic thatwill change the amplitude compression ratio CR from the value of 1 to the value of 2 when the signal level of the input signal S is increased across the signal level at -30 dB.

However, in the above-described conventional circuit arrangement, there arises a problem that the amplitude compression ratio CR abruptly changes between the front range and the rear range of the threshold point, and therefore, when the audio signal is reproduced in the conventional amplitude compressing/expanding circuit 1, the reproduced sound produces extremely unnatural feeling to listeners.

To solve the above problem, one conventional method has been proposed in such a manner that the amplitude compression ratio CR is gently changed by gradually changing the signal levels of the threshold point signal S_{H} and the compression ratio controlling signal Sp in accordance with a change in the signal level of the input signal while employing, for example, a ROM (read only memory) table.

Also, another conventional method has been proposed that the threshold point signal S_{H} and the compression ratio controlling signal Sp are controlled by the use of a control circuit of a processing circuit arrangement, instead of ROM table.

However, if such conventional methods are used, there arises another problem that the construction of the amplitude compressing/expanding circuit as a whole becomes complex, and therefore, such methods are not yet satisfactorily practicable in the recent technology.

Further, as the output signal So of the above-described amplitude compressing/expanding circuit, there is only obtained such a multiplied output signal So, depending upon the control signal S_{G} provided from the control signal generator circuit 4, and therefore, there is a problem that the operating characteristic cannot be made variable according to the frequencies of the input signal.

The capability of making the operating characteristic of amplitude compressing/expanding function variable with the frequencies of the input signal will be widely applicable to various aspects of the art specifically in handling audio signals. For example, it will be applied to the compensation for the audio signal of compressed amplitude to make up for the feeling of lack of the dynamic range according to the sense of hearing.

An amplitude expanding and/or compressing circuit for noise reduction purposes is described in GB-A-2 083 988. This circuit comprises the features of the characterizing part of claim 1. The signal multiplier means is arranged as a voltage-controlled amplifier which is located within a main path. The output signal of the main path is added to the output signal of a sub-path in an adder.

### SUMMARY OF THE INVENTION

Accordingly, it is an object of the present invention to provide an improved amplitude expander and/or compressor circuit which is free from above-mentioned drawbacks encountered in the prior art circuit.

It is another object of this invention to provide an improved amplitude expander and/or compressor circuit in which a desired input/output characteristics can be obtained with a relatively simple circuit construction.

An object of an embodiment of the present invention is to provide an improved amplitude expander and/or compressor circuit in which an input/output characteristics can be controlled in accordance with the frequencies of an input signal.

Further object of this invention is to provide an improved amplitude expander and/or compressor circuit in which an input signal can be normalized in a high speed with a simple circuit construction.

Still further object of this invention is to provide an improved amplitude expander and/or compressor circuit in which a smooth change in the amplitude compression ratio near the threshold level of the input signal can be obtained with a simple circuit construction.

Yet further object of this invention is to provide an improved amplitude expander and/or compressor circuit in which the amplitude compression ratio is changed smoothly even with a plurality of amplitude compression changing points.

The invention is set out in claim 1. The dependent claims 2-8 contain further embodiments of the invention.

### BRIEF DESCRIPTION OF THE DRAWINGS

For a better understanding of these and other objects of the present invention, reference is made to the following detailed description of the invention to be read in conjunction with the following drawings, in which:
Fig. 1 is a characteristic curve diagram used for explaining problems in the prior art amplitude compressing/expanding circuit;
Figs. 2 and 3 are schematic block diagrams of the conventional amplitude compressing/expanding circuit;
Fig. 4 is a schematic block diagram of a basic circuit arrangement of an amplitude compressing/expanding circuit according to the invention;
Figs. 5 through 12 illustrate characteristic curve diagrams used for explaining various operations of the amplitude compressing/expanding circuit shown in Fig. 4;
Fig. 13 is a characteristic curve diagram for showing a loudness curve;
Figs. 14 and 15 are characteristic curve diagrams for explaining operations of amplitude compressing/expanding circuits according to other preferred embodiments;
Fig. 16 is a schematic block diagram of one example of the control signal generator shown in Fig. 4;
Fig. 17 is a characteristic curve diagrams used for explaining operations of the amplitude compressing/expanding circuit shown in Fig. 16;
Figs. 18 and 20 are schematic block diagrams for showing a portion of the equivalent circuit shown in Fig. 16;
Figs. 19 and 21 are characteristic diagrams used for describing the operation of the control signal generator illustrated in Fig. 16;
Figs. 22 and 23 represent data example used for explaining the operation of the control signal generator shown in Fig. 16;
Fig. 24 is a schematic block diagram of a control signal generator according to another preferred embodiment;
Fig. 25 is a circuit diagram of a portion of the amplitude compressing/expanding circuit shown in Fig. 4;
Fig. 26 is a schematic block diagram for illustrating an equivalent circuit of the circuit shown in Fig. 25;
Fig. 27 to 30 are characteristic curve diagrams used for explaining the operations of the circuit shown in Fig. 25;
Fig. 31 is a schematic block diagram of an amplitude compressing/expanding circuit according to another preferred embodiment of the invention;
Fig. 32 is a schematic block diagram of an equivalent circuit of the circuit shown in Fig. 31;
Fig. 33 is a schematic block diagram of an amplitude compressing/expanding circuit according to a modified preferred embodiment of the invention; and,
Fig. 34 is a characteristic curve diagram used for explaining operations of the circuit shown in Fig. 33.

### DETAILED DESCRIPTION OF THE PREFERRED EMBODIMENT

One preferred embodiment according to the invention will now be described with reference to the accompanying drawings.

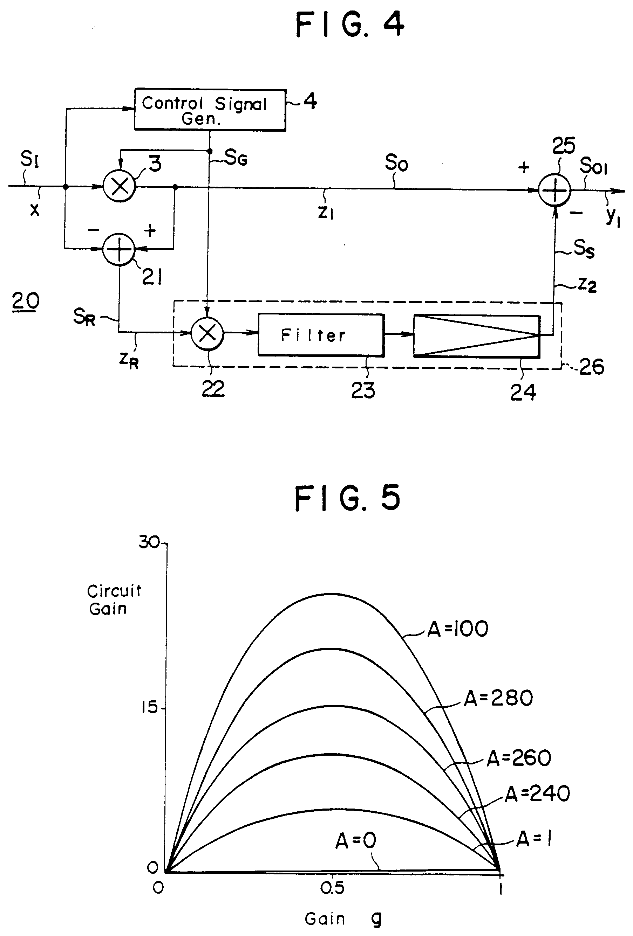

It should be noted that the same reference numerals shown in Fig. 2 will be employed as those for denoting the same or similar circuit elements shown in Fig. 4.

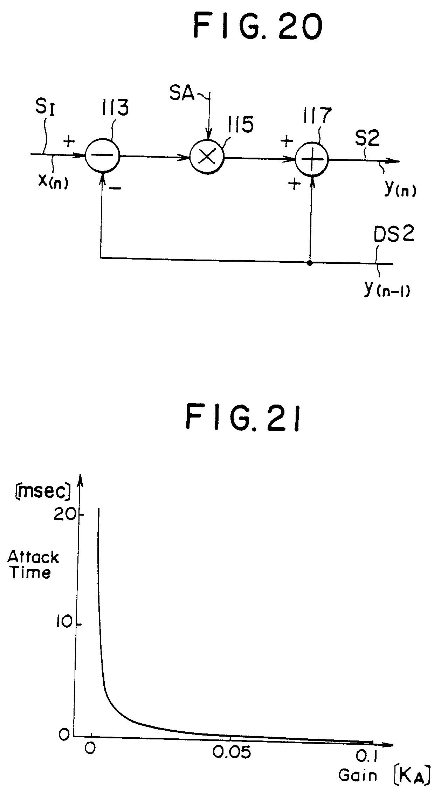

In the circuit arrangement shown in Fig. 4, 20 denotes an amplitude compressing/expanding circuit as a whole and the input signal S and the output signal So of the multiplier circuit 3 are received by an adder circuit 21 and a difference signal S_{R} therebetween is supplied to a multiplier circuit 22.

The multiplier circuit 22 receives the control signal S_{G} as well as the difference signal S_{R} and supplies a product (multiplied) output signal of these signals to an adder circuit 25 through a filter circuit 23 and an amplifier circuit 24.

As a result, in the adder circuit 25, when the multiplier circuit 3 is operated under the condition of an amplitude compressing operation with its gain set below 1, an output signal Sₛ whose phase is put in inverse relationship to with that of the output signal So through the amplifier circuit 24 is obtained, and the summation signal S₀₁ of these outputs signals Sₛ and So is delivered therefrom as its output signal.

That is, the amplitude compressing/expanding circuit 20 according to one preferred embodiment is constructed of a main pass circuit made up of the multiplier circuit 3 for amplifying the input signal S by the gain corresponding to the control signal S_{G} and for outputting the amplified signal therefrom, and a sub-pass circuit receiving the difference signal S_{R} and outputting the signal through the signal processing circuit26 constructed of the multiplier circuit 22, filter circuit 23, and the amplifier circuit 24.

Therefore, in the case where the signal level of the input signal S is below the threshold point or level, the gain "g" of the multiplier circuit 3 is set to a value of 1, and hence, the signal level of the difference signal S_{R} is kept at a value of 0, whereby the output signal So obtained by way of the main pass circuit is output through the adder circuit 25.

On the other hand, if the signal level of the input signal Sₗ rises across the threshold point, the gain "g" of the multiplier circuit 3 is switched to 1/2, and hence, the rise in the above-described signal level follows a rise in the signal level of the difference signal S_{R}, whereby the signal level of the output signal Sₛ provided by way of the sub-pass circuit is increased, and the proportion of the output signal Sₛ to the output signal So is correspondingly increased.

Thus, by setting the input/output characteristic of the signal processing circuit 26 forming the sub-pass circuit to a suitable value, it is possible to obtain a desired input/output characteristic which will provide gradual variation in the signal level, describing a gentle curve, of the output signal S₀₁ while the signal level of the input signal Sₗ is increased.

Now, by letting both the gain of the multiplier circuit 3 and that of the multiplier circuit 22 be "g" respectively, while representing a transfer function of the filter circuit 23 by F(m) and the gain of the amplifier circuit 24 by "A", an output signal So, whose amplitude Z₁ is given by the following equation, is obtained through the multiplier circuit 3

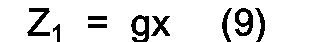

As a consequence, a difference signal S_{R} whose amplitude Z_{R} is given by the following equation can be obtained through he adder circuit 21 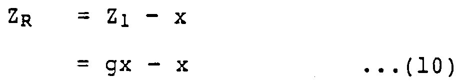 and an output signal Sₛ whose amplitude Z₂ is given by the following equation can be obtained through the signal processing circuit 26

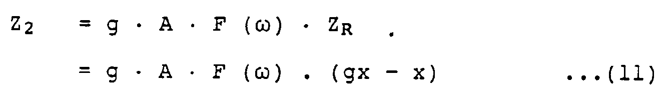

Therefore, based on equations (9) and (11), an output signal So whose amplitude y₁ is given by the following equation can be obtained

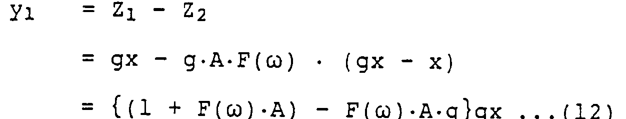

Then, letting the amplitude "x" and a transfer function F(ω) be x = 1, and F(ω) = 1 respectively, if the gains "g" of the multiplier circuits 3 and 22 are changed between values 0 to 1, it becomes possible to know output characteristics of the amplitude compressing/expanding circuit 20 at the times when the signal level of the input signal Sₗ is kept constant and the amplitude compression control signal S_{G} is varied.

That is, substituting these equations 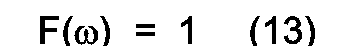 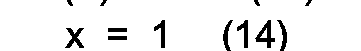 in equation (12), we obtain

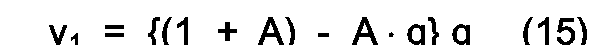

Then, the output characteristics, as shown in Fig. 5, are obtained, in which, while the gain "g" is varied between the value of 0 an a value of 1, the gain of the amplitude compressing/expanding circuit 20 as a whole is maximum at the gain "g" of a value of 0.5 and the gain of the circuit as a whole increases as the gain "A" of the amplifier circuit 24 is increased.

Further, when the gain A is kept at the value of 0, if the gain g is changed from the value of 0 to the value of 1, an output characteristic, in which the gain linearly increases therewith, of the main pass circuit only is obtained, and when the gain A is of other values than "0", the gains of the sub-pass circuit are superposed on the gain of the main pass circuit, and thereby, all the characteristics obtained have ascending inclinations toward the right shown in the characteristic curve diagram of Fig. 5.

Thus, by controlling the gain of the sub-pass circuit, the gain of the amplitude compressing/expanding circuit 20 as a whole can be controlled, and therefore, the output signal S₀₁ varying with a desired input/output characteristic corresponding to the provision of the sub-pass circuit for the main pass circuit can be obtained.

In the circuit arrangement of Fig. 4, if the transfer function F(m) of the filter circuit 23 is set to a value of 1, an operating characteristic providing a smooth change of the amplitude compression ratio CR is obtained, and further, by setting the gain A of the amplifier circuit 24 to a specific value, it becomes possible to perform both the amplitude compressing operation and amplitude expanding operation at the same time.

Here, the preferred embodiment will be examined as to the case where the threshold point is set to 0 dB and the amplitude compression ratio CR is to a value of 2.

In this case, it will be satisfied if the gain of the multiplier circuit 3 in the range above the threshold point is set to the value of x^{- ½} according to equation (5), and hence, the gain of the multiplier circuit 22 will also be set to the value of x^{- ½} in the range above the threshold point.

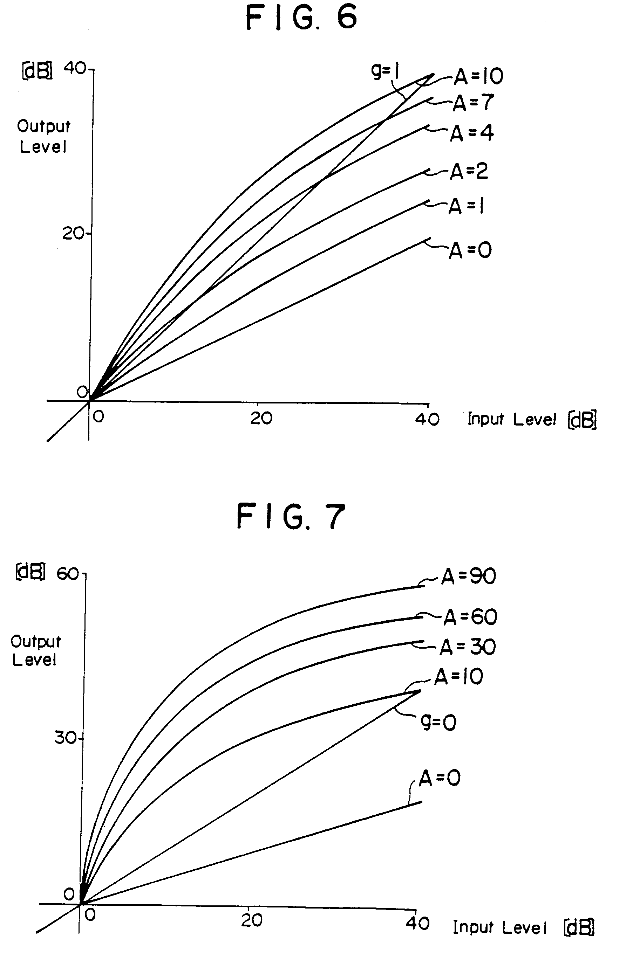

Then, in the range below the threshold point, the amplitude x_{R} of the difference signal S_{R} takes a value of 0, and therefore, an output signal S₀₁ proportional to the input signal S as shown in Figs. 6 and 7 is obtained.

Whereas, in the range above the threshold point, by substituting 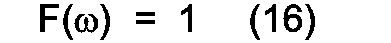 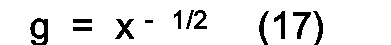 in equation (12), we obtain the relationship expressed as

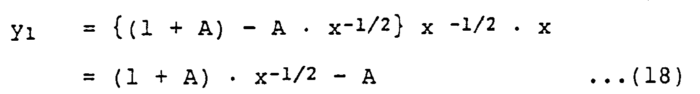

In this case, if the gain A is in the vicinity of the value of 1, it is know, when the signal level of the input signal S is increased over the threshold point, that the variation in the signal of the output signal S₀₁ is gradually decreases and it becomes parallel to the characteristic for the amplitude compression ratio CR of a value of 2 (namely, parallel to the input/output characteristic represented by a straight line when the gain A is the value of 0).

Thus, it is made possible according to the preferred embodiment to obtain an input/output characteristic providing such amplitude compressing action that the amplitude compression ratio CRwill slowly change from the value of 1 to the value of 2 after the signal level has crossed over the threshold point.

On the other hand, in the case where the gain A becomes higher than 3, such an input/output characteristic is obtained that the change in the signal level of the output signal S₀₁ in relation to the signal level of the input signal S abruptly increases when the signal exceeds over the threshold point, but, after the amplitude compression ratio CR has changed from the value of 1 to a value smaller than 1 (namely, after an amplitude expanding operation is performed), an input/output characteristic which gradually becomes as parallel to the input/output characteristic represented by the straight line when the gain A is of the value of 0, or cause the amplitude compression ratio CR to approach the value of 2, is obtained.

It is apparent that the greater a change becomes, the larger the gain A becomes.

As a consequence, a desirable input/output characteristic can be obtained according to the preferred em- bodimentwhich provides amplitude expansion effect after the threshold point has been crossed and then slowly turns to provide amplitude compression effect.

Now, another case where the amplitude compression ratio CR is further increased to 100, will now be examined. In this case, CR = 100 will be substituted in equation (5) and then we will obtain: 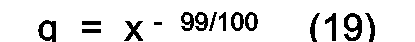 If this value is substituted for x^{- ½} in equation (18), we will obtain the relationship as expressed as

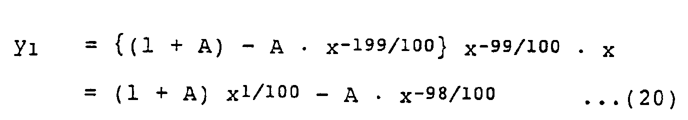

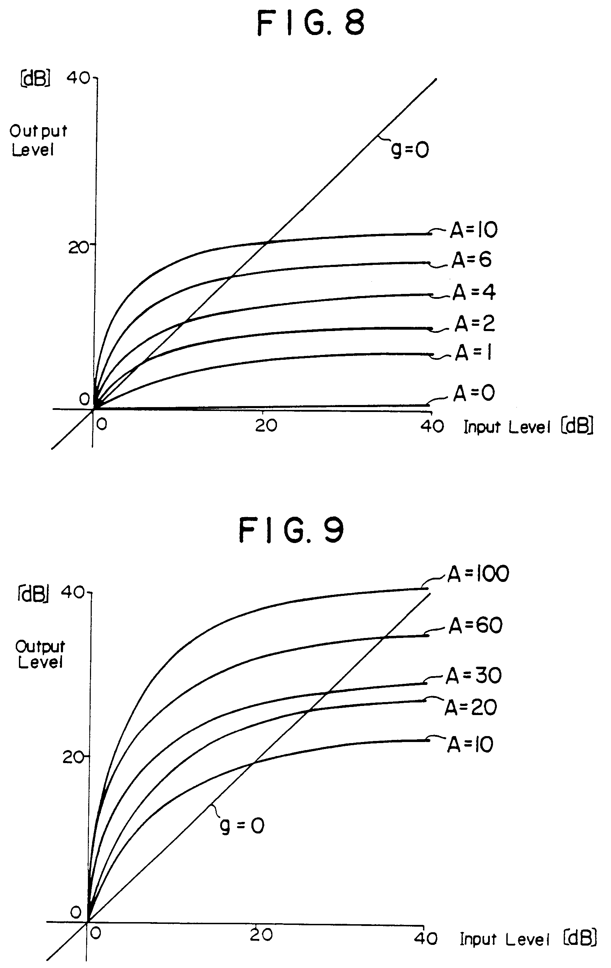

Also in this case, similarly to the case of Figs. 3 and 4, input/output characteristics as shown in Figs. 8 and 9 are obtained which, when the gain A is a value of 0, provides linearly varying amplitude compression ratio CR in the range beyond the threshold point, and when the gain A is in the vicinity of a value of 1, provides gently varying amplitude compression ratio CR from the value of 1 to the value of 100.

On the other hand, if the gain A is larger than the value of 2, such input/output characteristics are obtained which provide amplitude expansion effect to the degrees corresponding to respective values of the gain A and then slowly turn to provide the amplitude compression effect.

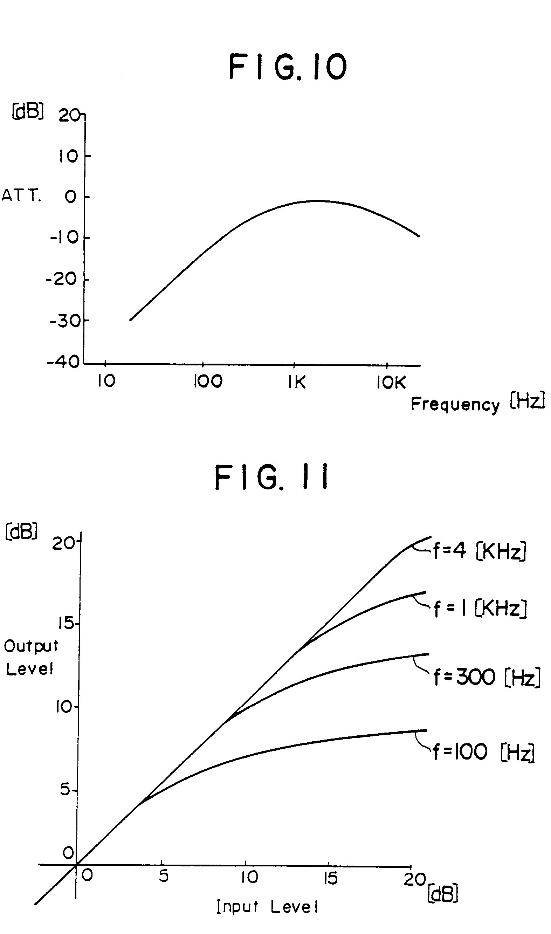

Now, a description will now be given of amplitude compressing/expanding operation in a case where a band-pass filter having a frequency characteristic as shown in Fig. 10 is used as the filter circuit 23 in the circuit arrangement of Fig. 4.

That is, the filter circuit 23 is constructed of a band-pass filter circuit whose center frequency is 2 - 3 KHz and is attenuating at 6 dB/OCT.

In this case, if the gain A of the amplifier circuit 24 is set to a value of 1 and the amplitude compression ratio CR is set to a value of 2, the following relationship is obtained from equation (12)

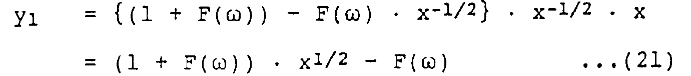

Since the first term of the right side of equation (21) includes the transfer function F(m), it is known that the amplitude compressing/expanding operation will change according to the frequency characteristic of the filter circuit 23.

That is, it is known form Fig. 11 that the amplitude compression ratio CR changes toward a value of 2 as the signal level of the input signal S is increased over the threshold point at 0 dB, and further, that the above-described change occurs slower, the closer to the center frequency of the band-pass filter the frequency is.

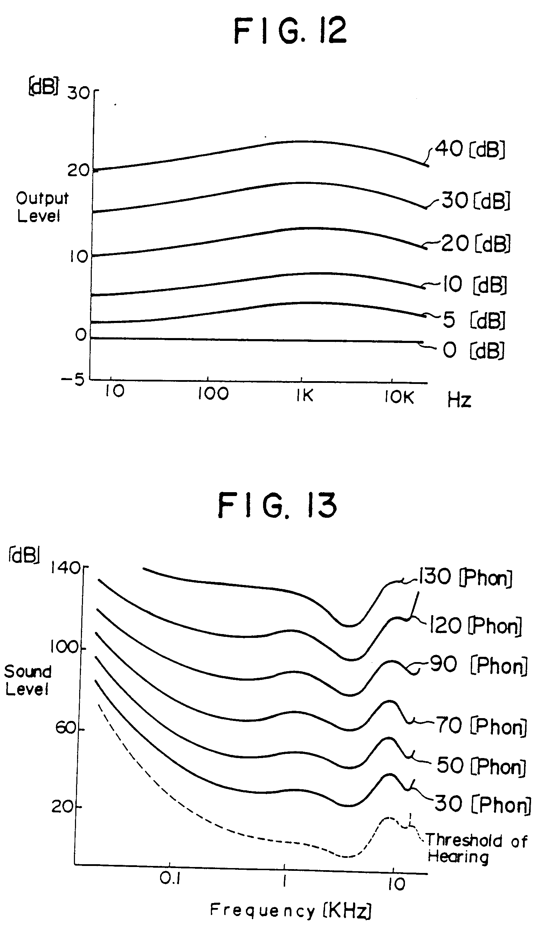

Further, if a case where certain input levels of input signal S are input is expressed with the frequency taken along the axis of abscissa as shown in Fig. 12, it is known that the amplitude compressing/expanding operation varies in the range up to around 15 dB of the input signal S_{I}, but the amplitude compression ratio CR becomes constant at the value of 2 in the range after the input signal S has exceeded over the level of around 20 dB.

Thus, it becomes possible according to the preferred embodiment to obtain an amplitude compressing/expanding circuit having an input/output characteristics with providing amplitude compressing/expanding action varying with the frequency of the input signal Sᵢ.

Referring now to Fig. 4, it will be arranged such that the gain A of the amplifier circuit 24 is set to around a value of 1 and a band-pass filter having its center frequency around 4 kHz, at which highest sensitivity to a listener is obtained, is used for the filter circuit 23.

If so arranged in this way, as described with reference to Figs. 11 and 12 above, an input/output characteristic providing slowly changing amplitude compression ratio as the signal level ofthe input signal is increased over the threshold point is obtained.

Therefore, it is made possible to obtain an audio signal with a compressed dynamic range adapted such that the unnaturalness in the reproduced sound due to an abrupt change in the amplitude compression ratio, is prevented from occurring.

Further it is enabled to obtain an input/output characteristic providing different amplitude compressing operation according to the frequencies of the input signal S_{I}, so that it becomes possible to cause the amplitude compression operation to be started most slowly when the input signal S is increased in level, and also the frequency of the input signal Sₗ comes to agree with the center frequency of the band-pass filter at 4 kHz.

Therefore, on the whole, the reduction in the dynamic range at around the center frequency of 4 kHz can be made correspondingly smaller than the reduction in the dynamic range at the other frequencies.

In reality, the human hearing is most sensitive to the frequency of 4 kHz as shown in Fig. 13, and therefore, when the dynamic ranges at other frequencies than the frequency of 4 kHz are reduced, a lack of dynamic range on the whole in the reproduced sound felt by the sense of hearing can be reduced correspondingly if then the dynamic range at around the frequency of 4 kHz is not reduced so much, and thus, the feeling of a lack of the dynamic range can be compensated for as sensed by hearing.

Therefore, not only the dynamic range of an audio signal obtained from a digital audio signal reproducing apparatus can be reduced without inducing unnaturalness, but also the resultant feeling of reduction in the dynamic range sensed by hearing can be reduced.

Hence, even when an audio signal obtained from a digital audio signal reproducing apparatus is heard where there is present background noise, where the volume of sound is not allowed to be made greater, or the like, the reproduced signal can be heard satisfactorily. Moreover, when the signal is recorded by an analog tape recorder, the recording can be be performed free from such troubles as deterioration in the S/N ratio and distortion of waveform.

According to the above-described circuit arrangement by constructing the signal processing circuit of an amplifier circuit, multiplier circuit, and a band-pass filter circuit, and by selecting the gain of the signal processing circuit at a predetermined value, an input/output characteristic can be obtained providing slow change in the amplitude compression ratio as the signal level of the input signal is increased and varying the amplitude compression action with the frequencies of the input signal.

Therefore, it is made possible according to the preferred embodiment to compress the dynamic range of an audio signal having a wide dynamic range as well as to reduce the feeling of a lack of dynamic range.

In the circuit arrangement of Fig. 4, a low-pass filter circuit may be used in lieu of the band-pass filter employed in the first preferred embodiment of the invention.

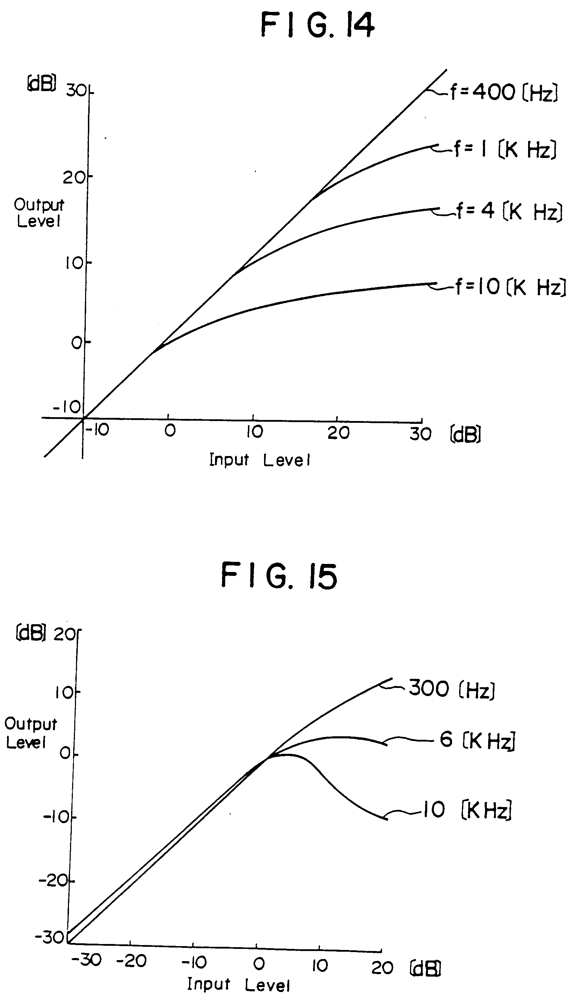

By so arranging, such an input/output characteristic can be obtained which, as shown in Fig. 14, provides the amplitude compression action to be started in the range where the signal level of the input signal becomes lower, the higher, the frequency of the input signal is.

In practice, there is a problem with a magnetic tape of an analog system, as shown in Fig. 15, that the output level of the recorded signal, when the frequency of the recorded signal becomes higher, is lowered even if the signal level of the recorded signal is increased higher than a specific value due to self-demagnetizing action.

Therefore, by arranging such that the recorded signal is supplied to the recording head through the amplitude compressing/expanding circuit according to the preferred embodiments, in which the amplitude compressing operation is started earlier in the rise of the signal level of the input signal, the higher the frequency of the input signal is, the lowering of the output level due to the self-demagnetizing action can correspondingly be prevented from occurring.

Although the preferred embodiments were described in the foregoing as to their cases where either the band-pass circuit or the low-pass fi Iter circuit was used for their fi Iter circuit, the present invention is not limited to that, but a high-pass filter, trap filter, or the like may be used as the need arises.

Although the embodiments were described above as to their cases where the filter circuit was used for providing the amplitude compression function varying with the frequencies of the input signal, the present invention is not limited to that, but the signal processing circuit may be formed of a multiplier circuit only.

In such a case, an amplitude compressing/expanding circuit can be obtained of which the input/output characteristic allows the amplitude compression ratio to be smoothly varied across the threshold point.

The signal processing circuit may be provided with either the amplifier circuit or the filter circuit only.

When only the amplifier circuit is provided therefore, by setting the gain of the amplifier circuit to a desired value, such an input/output characteristic can be obtained which provides the amplitude compressing function only when the level of the input signal comes within a specific range.

Also, in the case where only the filter circuit is used, when the signal level of the input signal is changed and the signal level of the difference signal is therefore changed, the signal level of the difference signal component passed through the fitter circuit to be added to the output signal of the main pass circuit correspondingly changes, and therefore, an input/output characteristic which provides a frequency characteristic varying with the signal level of the input signal can be obtained.

Hence, in this case, if it is arranged such that a low-pass filter circuit is used for the filter circuit, the highfrequency component of the input signal can be emphasized, or if a band-pass filter is used instead, the signal component of the pass band of the band-pass filter circuit can be emphasized.

As a result, if the arrangements of the above-described first and second preferred embodiments are modified so as to use only the filter circuit, the similar effects to those obtained by the first and second preferred embodiments will be obtained by use of simpler constructions as a whole.

A clipping circuit may be used in the signal processing circuit. By such a circuit arrangement, the output signal from the signal processing circuit can be clipped at a predetermined signal level, and therefore, it is made possible correspondingly to provide a desired change to the input/output characteristic of the amplitude compressing/expanding circuit as a whole.

Although the above-described preferred embodiments were described as to their cases where the amplitude compression ratio CR was set to the value of 1 in the range below the threshold point, the present invention is not limited to that, but the amplitude compression ratio CR below the threshold point can be set to other value than 1.

In such a case, by adapting such that a difference signal is obtained in the signal processing circuit when an input signal whose signal level exceeds above the threshold point is input, an input/output characteristic can be achieved with providing the amplitude compression ratio CR smoothly continuing from the aforesaid value below the threshold point to change into a desired amplitude compression ratio.

Further, in that case, if the amplitude compression ratio CR is set to a value less than 1, such an input/output characteristic is obtained that provides an amplitude expanding function in the range below the threshold point and an amplitude compressing function in the range across the threshold point slowly changing from the amplitude expanding function.

Further, by setting the gain "A" to a value larger than 2 and using only the range above the threshold point, an input/output characteristic can be obtained which provides slowly changing functions from an amplitude expanding function at an amplitude compression ratio CR dependent upon the gain "A" to an amplitude compressing function at an amplitude compression ratio CR determined by an amplitude compression ratio control signal So.

Although the above preferred embodiments were described as to the cases where the control signal was produced according to the signal level of the input signal, the present invention is not limited to be applied to such an arrangement, but may be applied to an amplitude compressing/expanding circuit wherein the control signal is produced according to the signal level of the output signal.

Further, in a digital audio signal processing system, by disposing such an amplitude compressing/expanding circuit employing a low-pass filter circuit in front of an encoder for the purpose of coding, the unpleasant sound to the ear due to quantization noise at the time of reproduction of female frictional sound, such as that formed of female audio signal when "sa" is pronounced, can be prevented from occurring.

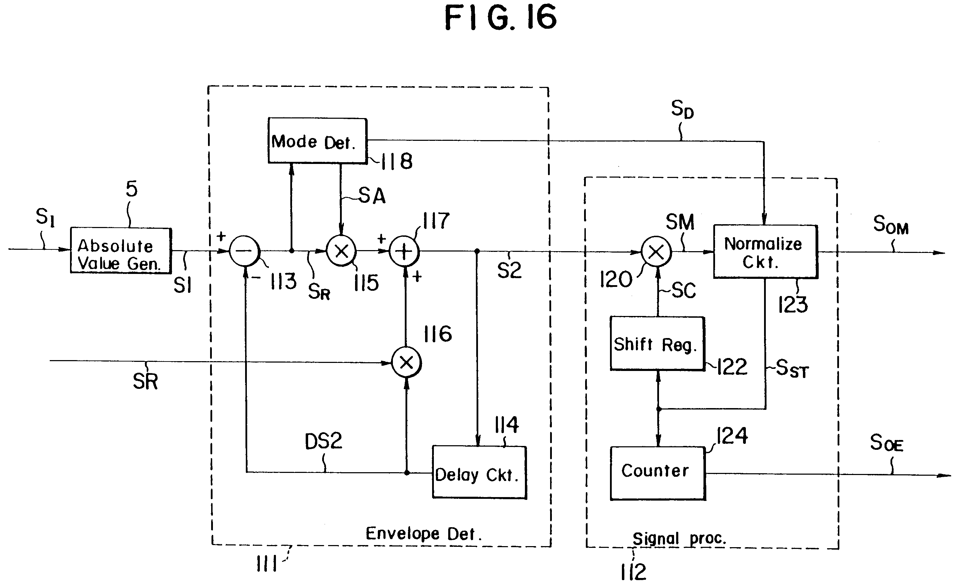

Referring now to Fig. 16, a circuit arrangement of the control signal generator circuit shown in Fig. 4 will be described in detail. In this circuit, digital information is supplied as the input signal 81, Therefore, this control signal generator circuit performs the digital signal processing.

In the control signal generator circuit of the amplitude compressing/expanding circuit, as illustrated in Fig. 16, a signal processing circuit 112 receives an absolute value signal S1 formed of a sequence of digital information outputfrom the absolute value circuit 5 through the envelope detector circuit 111 at the signal processing circuit 112, and also output both normalized digital signals S_{oM} and S_{oE} to the logarithmic converter circuit 7 (see Fig. 3).

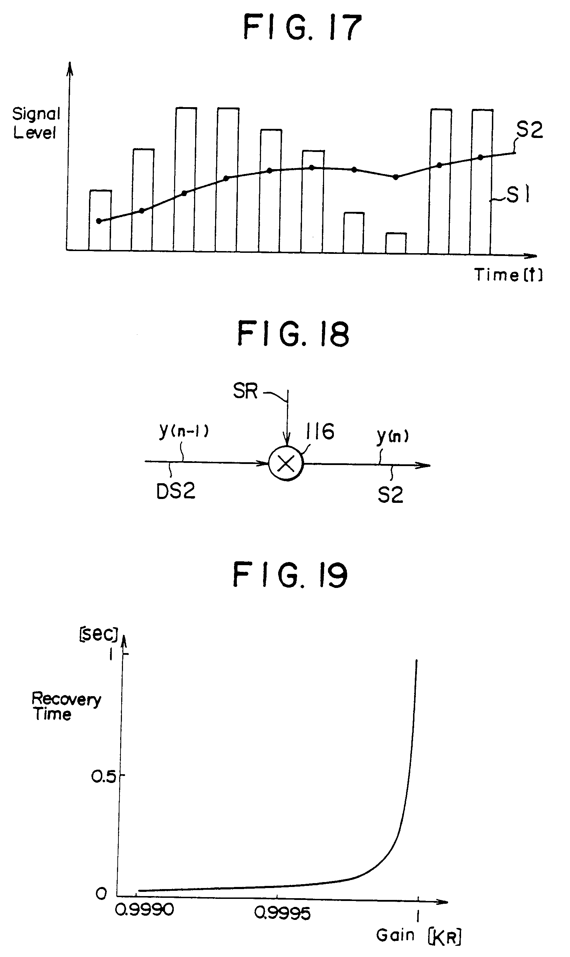

Therefore, as shown in Fig. 17, the envelope detector circuit 111 sequentially receives the absolute value signal S1, which is output from the absolute value circuit 5 based upon the digital audio signal 8₁ and is made up of 16 positive bits formed of two's compliment data, and then outputs a digital product signal S2, which rises, or falls, in a predetermined attack time, or recovery time, dependent upon the variation in the values of the absolute value signal S1, to the signal processing circuit 112.

That is, in the envelope detector circuit 111, a subtractor circuit 113 receives the absolute value signal S1 and a delayed envelope detection signal DS2, by way of a delay circuit 114, which is a signal obtained by delaying by one clock period, a digital product signal S2 corresponding to the absolute value signal S1, and thereupon, outputs a difference signal S_{R} between the absolute value signal S1 and the delayed envelope detection signal DS2 to both a multiplier circuit 115 and a mode detector circuit 118.

Therefore, the difference signal S_{R} of a positive value is produced when the value of the absolute value signal S1 is larger than that of the delayed envelope detection signal DS2, whereby it can be detected that the amplitude of the digital audio signal 8₁ is in an increasing condition.

Conversely, when the value of the absolute value signal S1 is smaller than that of the delayed envelope detection signal DS2, the difference signal S_{R} of a negative value is produced and it is known that the amplitude of the digital audio signal 8₁ is in a decreasing condition.

A mode detector circuit 118 detects the value of the difference signal S_{R}, and when the value of the difference signal S_{R} is positive or zero (hereinafter to be referred to as the "attack mode"), switches the value of the attack time control signal SAso that the gain of the multiplier circuit 115 is controlled to become value 0.02.

In contrast thereto, when the value of the difference signal S_{R} is negative (hereinafter to be referred to as the "recovery mode"), the gain of the multiplier circuit 115 is controlled to become zero.

As a result, while an output signal whose value is the value of the difference signal S_{R} between the delayed envelope detection signal DS2 and the absolute value signal S1 multiplied by 0.02 is obtained in the attack mode, the output signal is set to zero in the recovery mode.

On the other hand, a multiplier circuit 116 receives the delayed envelope detection signal DS2 and simultaneously a recovery time control signal SR, and then outputs an output signal whose value is 0.9998 times as large as that of the delayed envelope detection signal DS2.

An adder circuit 117 adds up the output signals of the multiplier circuits 115 and 116 and outputs the summation as the digital product signal S2.

Therefore, the envelope detector circuit 111 in the recovery mode can be represented by an equivalent circuit as shown in Fig. 18, and by denoting the value of the digital product signal S2 by y(n), the value of the delayed envelope detection signal DS2 by y(n-1), and the gain of the multiplier circuit 116 by K_{R}, a relationship as expressed below is obtained

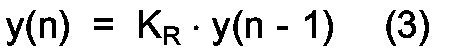

As a result, even when the value of the absolute value signal S1 changes from its maximum value to minimum value, such a digital product signal S2 that slowly decreases in a value corresponding to the gain K_{R} of the multiplier circuit 116 can be obtained. And in this case because the gain K_{R} is selected to be 0.9998, it is known that, even when the value of the digital product signal S2 obtained one clock period before was the maximum value of 16-bit data and the value of the absolute value signal S1 is the minimum value of the 16-bit data, only one bit position at most of bit shifting is required for normalization of the digital product signal S2 with reference to the digital product signal S2 obtained one clock period before.

In practice, as illustrated in Fig. 19, since the sampling frequency in the CD player is set to 48 kHz, a practically sufficient value around 50 msec can be obtained as the recovery time by virtue of selection of the gain K_{R} of the multiplier circuit 116 at the value 0.9998.

By contrast, in the attack mode, since the gain K_{R} is expressed as 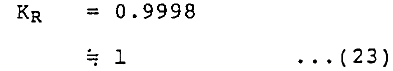 the circuit can be represented by an equivalent circuit as shown in Fig. 20, and by denoting the gain of the multiplier circuit 115 by K_{A} and the value of the absolute value signal S1 by x(n), we can obtain a difference signal S_{R} whose value Z(ₙ) is expressed as

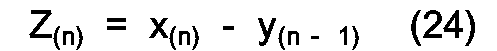

Therefore, through the adder circuit 117, we can obtain a digital product signal S2 whose value y(n) is expressed as

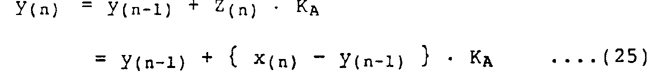

Therefore, although the value of the digital product signal S2 changes most greatly when the value of the digital product signal S2 was at the minimum and an absolute value signal S1 at the maximum in a value is input in succession thereto, by virtue of setting the gain K_{A} of the multiplier circuit 115 to the value 0.02, relative to the 16-bit digital product signal S2, it is know that the normalization of the 16-bit digital product signal S2 is achieved by bit-shifting of only 9-bit positions at most with reference to the digital product signal S2 obtained one clock period before.

In practice, as shown in Fig. 21, because of the setting of the gain K_{A} of the multiplier circuit 116 to the value 0.02, a practically sufficient value around 1 msec can be obtained as the attack time.

Thus, a digital product signal S2 formed of a sequence of digital information can be obtained whose level varies following the amplitude value of the absolute value signal S1 in the attack time and recovery time of 1 msec and 50 msec.

The signal processing circuit 112 receives the digital product signal S2 at its multiplier circuit 120 and outputs therefrom a digital product signal SM based upon a control signal SC output from a shift register 22, and thereby, supplies a bit-shifting operation previously to the digital information of the digital product signal S2 by a bit-shift quantity required for normalization of the digital information of the digital product signal S2 received one clock period before.

That is, a shift register circuit 122, constructed of a 15-bit reversible shift register circuit, is adapted, responding to a bit shift signal S_{ST} output from a normalization circuit 123, to cause data of logical value "1"stored in the shift register circuit 122 to be shifted by one bit position at a time.

Therefore, in the case where a bit shifting operation by m-bit positions was applied to its digital information for normalization of the digital product signal S2 received one clock period before, it is arranged in the shift register circuit 122 such that the logical value of the m-th bit from the least significant bit (LSB) is logical "1".

The shift register circuit 122, based upon the aforesaid logical level, outputs a control signal SC, so that a digital product signal SM whose value is 2ₘ times as large as that of the digital product signal S2 input to the multiplier circuit 120 is output therefrom to the normalization circuit 123

Since, at this time, 9 bit positions and one bit position, at most, of bit shifting are required for normalization both in the attack mode and recovery mode, respectively, with reference to the digital information processed one clock period before, it is adapted such that digital information formed of a bit length 9-bit length larger than that of the input digital information to the multiplier circuit 120 (namely, that formed of a bit length of 25 bits in all) is output to the normalization circuit 123.

Thus, the digital information of the digital product signal SM supplied to the normalization circuit 123 is input thereto after being applied with a bit-shifting operation by the bit-shift quantity "m", which was required for the normalization of the digital information processed one clock period before.

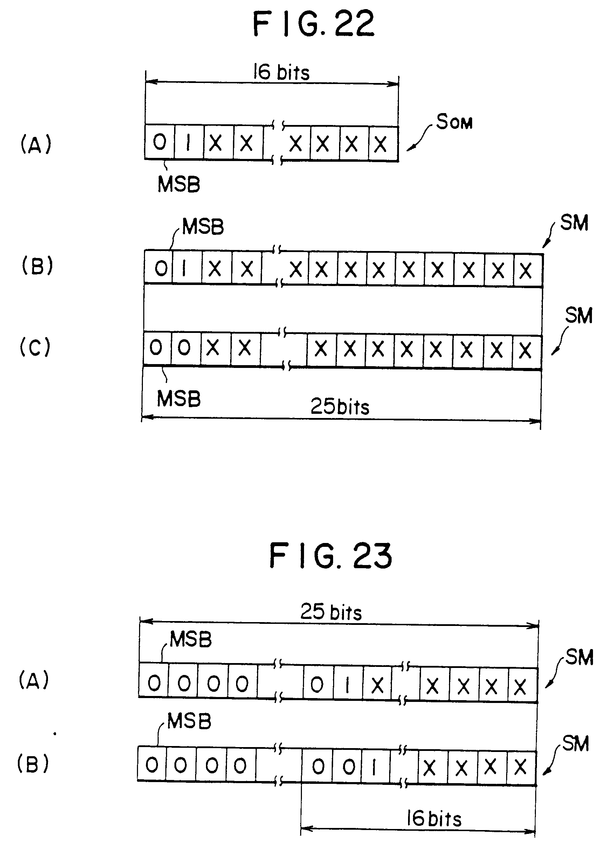

The normalization circuit 123 receives a mode detection signal So output from a mode detector circuit 118 depending upon the attack mode or recovery mode, and normalizes, as shown in Fig. 22, the digital product signal SM according to the mode detection signal So so that the logical value of the second bit from the most significant bit (MSB) of the data of a 16-bit length may come to logical "1" (Fig. 22(A)).

More particularly, in the attack mode, a digital product signal SM, whose bits are shifted and the logical values of two bits in the highest positions of the 25-bit long data thereof are both "0" and "1" (Fig. 22 (B)) or the logical values of the two bits in the highest positions thereof are both "0" (Fig. 22(c)), is input to the normalization circuit 123.

Then, the normalization circuit 123 detects the logical value of the second bit from the most significant bit, and performs the bit shifting operation to the digital information toward the higher order until the logical value of the bit in question comes to logical "1".

Further, it outputs the bit shift signal S_{ST} corresponding to the supplied bit sift quantity, and at the same time, outputs the high-order 16 bits of the digital information finished with the bit-shifting to the logarithmic converter circuit 7 (Fig. 3) as the mantissa of envelope detection signal S_{oM}.

On the other hand, in the recovery mode, as shown in Fig. 23, the digital product signal SM whose bits are arranged so that the logical values of the bits from the most significant bit to the tenth bit of the 25-bit long data are logical "0" in succession and the logical value of the 11th bit is logical "1" (Fig. 23(A)), or the logical values of the bits from the most significant bit to the 11th bit are logical "0" in succession and the logical value of the 12th bit is logical "1" (Fig. 23(B)), is input to the normalization circuit 123.

Therefore, the normalization circuit 123, in the recovery mode, detects the logical value of the 11th bit from the most significant bit, and when the logical value of that bit is logical "0", causes bit shifting for one bit position toward the most significant bit.

In succession thereto, in the recovery mode, the normalization circuit 123 outputs the data of a 16-bit length from the least significant bit as the exponent of normalized data. Thus, the exponent of normalized envelope detection signal S_{oM} in both attack mode and recovery mode can be obtained.

At hose time, by virtue of the previously applied bit shifting by the bit-shift quantity "m" which was required for normalization of the digital product signal SM processed one clock period before, normalization of the digital product signal SM in the attack mode is achieved by making only 9 bit positions at most of bit shifting, or normalization of the digital product signal SM in the recovery mode is achieved by making only one bit position at most of bit shifting.

Therefore, as compared with the prior art case where digital information is sequentially normalized, the number of times for bit shifting in all in the present case can be reduced corresponding to the normalization previously applied according to the quantity required for normalization performed one clock period before.

As a result, the processing time required for the bit shifting can correspondingly be shortened and the processing simplified, and a signal processing circuit of the correspondingly simplified circuit arrangement as a whole can be achieved.

In connection with the described arrangement, a counter circuit 124, which is formed of a reversible counter, increases or decreases its count value obtained one clock before in response to the bit shift signal S_{ST}, and thereby updates the exponent of the envelope detection signal S_{oE} corresponding to the mantissa of the envelope detection signal S_{oM} obtained one clock period before and outputs the exponent of the envelope detection signal S_{oE} to the logarithmic converter circuit 7 (Fig. 3).

At the same time, the shift register circuit 122 shifts the bit of logical value "1" according to the bit shift signal S_{ST} and thereby records the bit shift quantity required for the normalization of the digital information in the current clock period.

In the described manner, the envelope detection signals separated to exponent and mantissa S_{oM} and S_{oE} and output and passed through the logarithmic converter circuit 7, clipping circuit 8, multiplier circuit 10, and the exponential converter circuit 11 (Fig. 3), whereby a specified control signal S_{G} can be obtained, and thus, a control signal generator circuit producing small calculation error as a whole, capable of high speed processing, and being of a simplified circuit arrangement as a whole can be realized.

In the described circuit arrangement, the digital audio signal Sₗ is converted into the absolute value signal S1 and then input to the envelope detector circuit 111.

As the result, the digital product signal S2 varying in predetermined attack time or recovery time is obtained through the envelope detector circuit 111.

In the signal processing circuit 112, the digital product signal S2 is previously subjected to bit shifting by the bit-shift quantity required for normalization of the digital product signal S2 received one clock period before and then subjected to bit shifting in the normalization circuit 123 according to the attack mode or recovery mode to be normalized.

As the result, the mantissa and exponent information of the digital product signal S2 are obtained in the normalization circuit 123 and the counter circuit 124 responding to the bit shift signal S_{ST} output from the normalization circuit 123, and thus, the normalized envelope detection signals S_{oM} and S_{oE} are output from the signal processing circuit 112.

According to the above described circuit arrangement, by virtue of the normalization of the digital product signal S2 performed after the signal received by the signal processing circuit 112 has been, subjected to bit shifting by the bit shift quantity that was required for the normalization performed one clock period before, a signal processing circuit performing the signal processing in a simpler manner as a whole and in a shorter processing time and further being of a simpler circuit arrangement as a whole can be obtained.

Therefore, a control signal generator circuit of a correspondingly simpler circuit arrangement as a whole, producing smaller errors, and capable of speedier operational processing can be obtained.

Although the above embodiment was described as to its case where the attack time and the recovery time are set to 1 msec and 50 msec, the present invention is not limited thereto, but may be widely applied to other cases where a digital signal varying in different values of the attack time and recovery time is subjected to a normalization process in floating point arithmetic.

In such a case where the attack time and recovery time are changed, the bit length of the digital information input to the normalization circuit may be suitably selected in accordance with the changed attack time and recovery time and corresponding bit shifting processes may be performed in the normalization circuit.

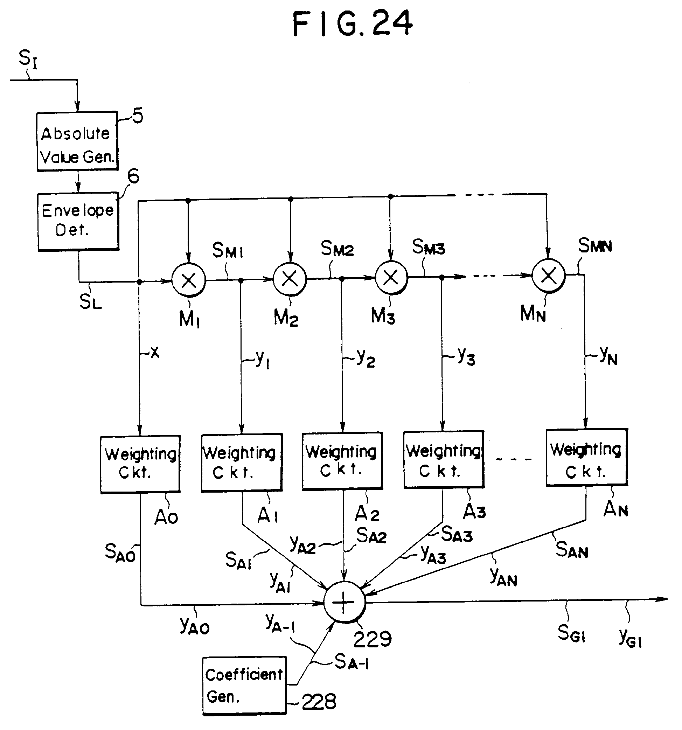

Subsequently, a control signal generator circuit according to anotjher preferred embodiment will now be described with reference to Fig. 24.

In Fig. 24, an input signal S1 composed of a digittal audio signal having an amplitude "X" is supplied via an absolute value circuit 5 to an envelope detector 6 so as to envelope-detected, so that a detected signal S_{L} having a signal level proportional to the signal level "X" of the input signal Sₗ is obtained.Multiplier circuits M_{1'} M₂, M₃, ---, M_{N}(N being an integer) which are series-connected to each other to form an N-series-connected multiplier circuits, receive the detected signal S_{L} at each of their input terminals. Accordingly, gains of these multiplier circuits are controlled in response to the signal level of this detected signal S_{L}. The detected signal S_{L} is supplied to one end at the multiplier circuit M₁ as the input signal.

As a result, in the multiplier circuit M_{1'} assuming that the signal level of the detected signal S_{L} is indirect proportion to the signal level "X" of the input signal Sₗ at the proportion constant of 1, a signal level "Yᵢ" of a multipliered signal S_{M1} is obtained, which level is expressed as: 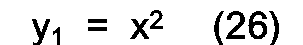 In contrast, another signal level "y2' of a multiplied signal S_{M2} is obtained, which level is expressed in the succeeding multiplier circuit M₂ by the following eguation:

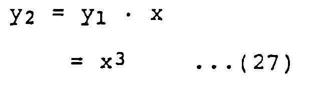

As a consequence, in tne multiplier circuits M₁ through M_{N}, the signal levels _{Y1}, _{Y2}, y₃, ---, _{YN} of the respective multiplier signals S_{M1}, S_{M2}, S_{M3}, ---, S_{MN} can-be produced which are expressed as the following generic formulae:

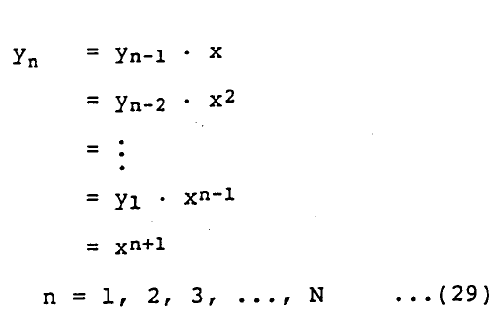

With the above-described arrangement, both the absolute value circuit 5 and envelope detector circuit 6 constitute the detector means for detecting the signal level of the input signal Sₗ, whereas the multiplier circuits M₁ through M_{N} constitute the multiplier means for performing multiplication on tne detector results at a predetermined multiplication number with a coefficient defined in accordance with the detector results which are obtained from the detector means.

Moreover, this control signal generator circuit includes (N + 1) sets of weighting circuits Aₒ, A_{1'} A₂, A3, ---, AN which are constructed of amplifier circuits, and output both the input signal Sₗ and the respective multiplier signals S_{M1}, S_{M2}, S_{M3}, ---, S_{MN} via the respective weighting circuits Aₒ, A_{1'} ---, AN to the adder circuit 229.

Accordingly, when the weighting coefficients of the respective weighting circuits Aₒ, A_{1'} ---, AN are expressed by values Cₒ, C₁, C₂, C₃, ---, C_{N}, an output signal S_{AO} having a signal level y_{Ao} can be obtained via the first weighting circuit Aₒ which is represented by the following equation:

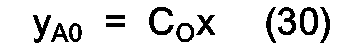

To the contrary, in the remaining weighting circuits A₁ to AN, output signals S_{A1}, S_{A2}, S_{A3}, ---, S_{AN} having a signal level Y_{AN} can be obtained which are generally expressed by the following eqaution:

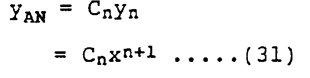

The adder circuit 229 receives the above-described output signals S_{A0} to S_{AN}, and also output signal S_{A-} derived from a coefficient generator circuit 228 (the signal level of which corresponds to a signal level expressed by a value C₋₁ corresponding to the output signals S_{A0} to S_{AN}), and then outputs its resultant adder signal as a control signal S_{G1}.

As a consequence, the control signal S_{G1} having a signal level y_{G1} can be produced via the adder circuit 229 from the above-described equations (30) and (31), which is expressed by the following equations.

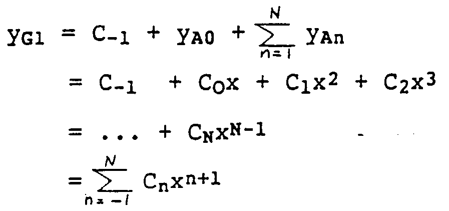

As previously described in detail, the weighting circuits Aₒ to AN constitute weighting means for weighting the detected signal S_{L} and multiplied signals S_{M1} to S_{MN} by predetermined weighting amounts, whereas the adder circuit 229 constitutes adder means for summing the output signals S_{AO} to S_{AN} which have been obtained by way of the weighting operation.

Consequently, when the amplitude compressing/expanding circuit is constructed of the above-defined circuit arrangement by setting the weighting circuits Aₒ to AN and the weighting coefficients C₁ to C_{N} of the coefficient generator circuits 228 to predetermined values, the input/output characteristics indicated by the high order function formula can be obtained. As a result, such input/output characteristics that the amplitude compression ratio varies complexly with a simpler circuit arrangement as a whole, can be achieved.

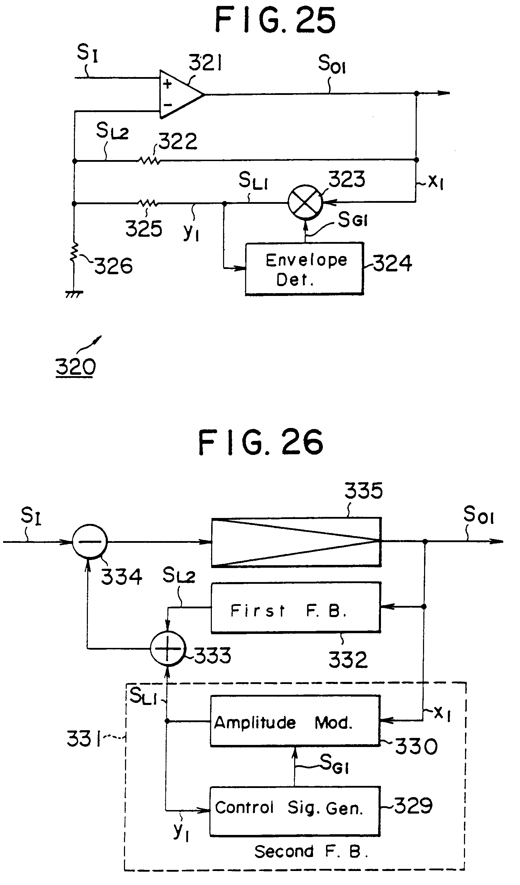

Referring now Fig. 25, another preferred embodiment of the multiplier circuit 3 and the control signal generator 4 shown in Fig. 4 will be described.

In Fig. 25, reference numeral 320 represents as a whole, both the multiplier circuit 3 and the control signal generator 4 illustrated in Fig. 4. This circuit arrangement receives, as an input signal, a voice signal 8₁ at its non-inverting input terminal of an operational amplifier circuit 32, having a sufficient gain more than 50 dB, and obtains from the output terminal of the above-described operational amplifier circuit 321, an output signal S₀₁ which has been processed by the amplitude compression/expansion manner.

The operational amplifier circuit 321 has a resistor 322 which functions as a first feedback circuit by which an amplitude gain can be maintained at a constant value even when the signal level of the output signal S₀₁ is changed. Also this operational amplifier circuit 321 owns a second feedback circuit which is constructed of a multiplier circuit 323, the amplitude gain of which is correspondingly increased when the signal level of the output signal S₀₁ is increased, and also of an envelope detector circuit 324 for controlling the amplitude gain of this multiplier circuit 323.

More specifically, the envelope detector circuit 324 produces the control signal S_{G1} direct proportion to the output signal S_{L1} of this multiplier circuit 323 in response to the output signal S_{L1}, in order that the amplitude gain of the multiplier circuit 323 is controlled. As a result, the input/output characteristics of the multiplier circuit 323 can be changed in response to the signal level of the output signal Sₒₗ.

In addition, the output signal S_{L1} of the multiplier circuit 323 is supplied via the resistor 325 to the non-inverting input terminal of the operational amplifier circuit 321 which is ground via the resistor 326, together with the output signal S_{L2} of the resistor 322, so that a summation signal derived from the first and second feedback circuits is fed back to the operational amplifier circuit 321.

As a result, as illustrated in fig. 26, assuming that the circuit 320 is represented by an equivalent circuit, the envelope detector circuit 324 constitutes a control signal generator circuit 329, whereas the multiplier circuit 323 constitutes an amplitude modulator circuit 330, the amplitude gain of which is varied in accordance with the control signal S_{G1},and also constructs the second feedback circuit 331 together with the control signal generator circuit 329.

In contrast thereto, the resistor 326 constitutes the adder circuit 333 for adding both the output signals S_{L1} and S_{L2} of the first snd the second feedback circuits 332 and 331 formed by the resistor 322, and the operational amplifier circuit 321 constitutes a subtracter circuit 334 which subtracts the output signal of the adder circuit 333 from the voice signal S, and also the amplifier circuit 335 having a predetermined gain.

Accordingly, the circuit 320 is constructed of a feedback amplifier circuit including two feedback circuit 331 and 332, so that the input/output characteristics of both the first and second feedback circuits 332 and 331 determine those of the entire circuit 320.

It should be noted in the circuit 320 shown in Fig. 25 that the feedback gains of both the first and second feedback circuits 332 and 331 are equal to each other when the voice signal 8₁ having a predetermined signal level is input. Simultaneously, in the first feedback circuit 332, the total gain of the circuit 320 is set to a value of 1.

As a consequence, in the circuit 320 shown in Fig. 25, such input/output characteristics can be obtained which are determined by the input/output characteristic of the first or second feedback circuit 332 or 331 at the boundary of the signal level. When the signal level of the output signal is increased, the amplitude gain of the multiplier circuit 323 is correspondingly increased, so that the circuit 320 varied in accordance with the input/output characteristics which can be determined from the first feedback circuit 332 and second feedback circuit 321, can be obtained with an increase of the signal level of the voice signal Sₗ at the boundary of the signal level. Accordingly, if this signal level is set to the signal level obtained at the threshold point, the circuit 320 having an input/output characteristic can be obtained, which is changed into the input/output characteristic determined by the first and second feedback circuits 332 and 331 at the boundary of this threshold pooint.

In addition, since the summation signal derived from the first and second feedback circuit 332 and 331 is fed back, the input/output characteristic which can be determined by the first feedback circuit 332 at the boundary of the threshold point, can be varied into the input/output characteristic determined by the second feedback circuit 331.

Accordingly, when both the input/output characteristics of both the first and second feedback circuits 332 and 331 are selected to be desirable, input/output characteristic of the circuit 320 can be smoothly changed in such a manner that it is changed from the input/output characteristic determined by the first feedback circuit 332 to the input/output characteristic determined by the second feedback circuit 331.

If at this time, the amplitude of the output signal S₀₁ is equal to a value of _{X1}, and also the amplitude of the output signal S_{L1} derived from the multiplier circuit 323 is equal to a value of yₗ, and furthermore, the gain of the multiplier circuit 323 is equal to a value of gₗ, then the below-mentioned equation expressing a relationship is given:

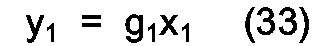

To the contrary, if in the envelope detector circuit 324, the proportion constant is equal to a value of "m", another relationship indicated by the following equation is given:

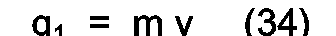

Now, if the proportional constant "m" is equal to a value of 1, the following equation is obtained from the equations (33) and (34);

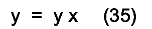

Accordingly, when the equation (35) is simplified, the following equation is given;

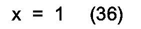

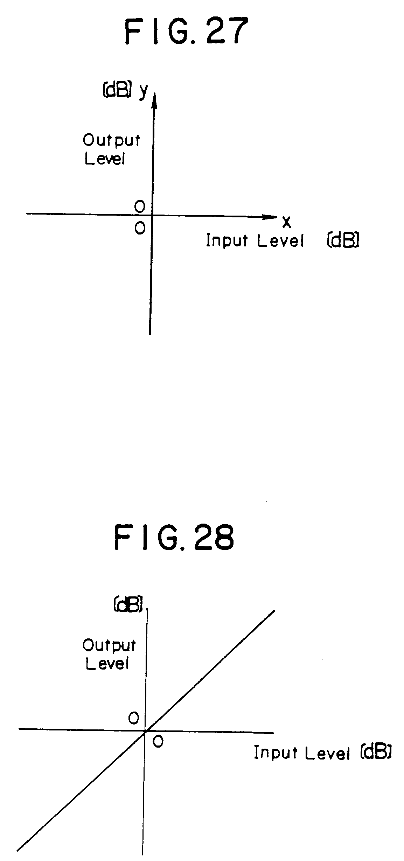

As a consequence, as illustrated in Fig. 27, the input/output characteristic for the amplitude gain of the second feedback circuit 331 can be obtained, the output level of which is changed with respect to the input level to the infinitive signal level.

To the contrary, as shown in Fig. 28, in the first feedback circuit 332, such an input/output characteristic can be obtained that the output level is changed direct proportion to the input level under the proportional constant of 1.

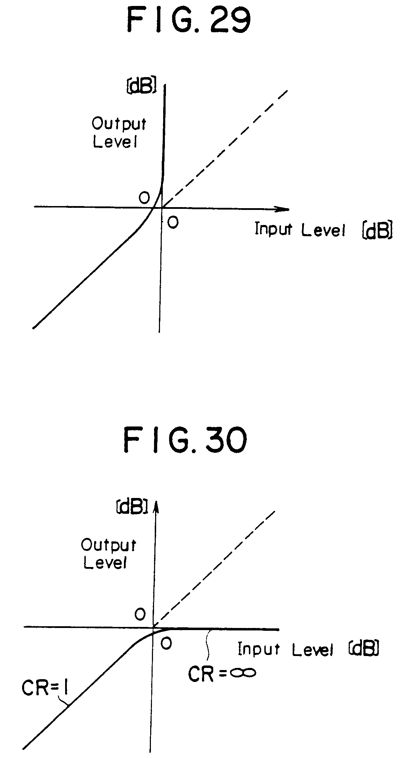

As a result, as illustrated in Fig. 29, as to the summation signal derived from the first and second feedback circuits 332 and 331, the following input/output characteristic can be obtained at the boundary of the input level at which both the output levels of the first and second feedback circuits 332, and 331 become equal. That is, the input/output characteristic is smoothly changed from the input/output characteristic of the first feedback circuit 332, as described in Fig. 23, to that of the second feedback circuit 331 in accordance with an increase of the input level.

Consequently, the input/output characteristic of the entire circuit 320 is expressed by the reverse characteristic of the first and second feedback circuits 322 and 321, as illustrated in Fig. 30. The amplitude compression ratio CR can be smoothly varied with respect to the boundary of the threshold point (0 dB at the input signal in the preferred embodiment), from a value of 1 represented by the proportional constant of "1" to the infinitive value represented by the proportion constant of "0".

Moreover, in the preferred embodiment, the first feedback circuit 332 is constructed of a resistor circuit, and the second feedback circuit 331 is constructed of the envelope detector circuit 324 for controlling the gain of the multiplier circuit 323, so that the amplitude gains of the first and second feedback circuits 332 and 331 can be set at an extremely high accuracy.

As a consequence, the signal level at the threshold level can be set at a high accuracy, and since the entire circuit is constructed of the feedback circuit, the higher stability can be achieved for, as a whole, the temperature, supply voltage and so on.

In a practical case, according to the conventional amplitude compressing/expanding circuit, the signal level at the threshold point must be set by the circuit network employing the non-linear circuit element such as the clipping circuit. As a result, there is no effective solution to prevent the fluctuation in the operation level of the non-linear circuit element, and also there is a problem that the temperature characteristics are not so sufficiently stable as a whole.

However, according to the preferred embodiment of the invention, these conventional problems can be effectively solved.

With the above-described circuit arrangement, in case that the signal level of the voice signal 8₁ is lower than the threshold point, the entire input/output characteristic of the circuit 320 can be set by the amplitude gain of the resistor 322 which constitutes the first feedback circuit 332, and therefore the input/output characteristic where the amplitude compression ratio CR is equal to a value of 1 as a whole.

To the contrary, when the signal level of the voice signal 8₁ is gradually increased, the amplitude compression ratio CR is gradually changed due to the amplitude gain of the second feedback circuit 331, accordingly. When the signal level of the voice signal 8₁ exceeds over the threshold point, the input/output characteristic where the amplitude compression ratio CR becomes infinitive due to provision of the second feedback circuit 331, can be obtained.

According to the above-described circuit arrangement, the second feedback circuit the amplitude gain of which is varied in response to the signal level of the input signal, is employed with respect to the first feedback circuit the signal level of which is constant, with result that the entire circuit can be simply constructed, and the input/output characteristic of the circuit where the amplitude compression ration CR is smoothly varied from the value of 1 to the infinitive value.

In addition, according to the preferred embodiment of the invention, since the entire input/output characteristic of the circuit 320 can be determined by the summation signal of the first and second feedback circuits, even if no non-linear circuit element is employed in the first and second feedback circuits, the amplitude compression ratio CR can be changed with respect to the desired threshold point. As a consequence, the threshold point can be set at the high accuracy as a whole, as compared with the conventional circuit arrangement, and also the amplitude compressing/expanding circuit having the stable temperature characteristics can be obtained.

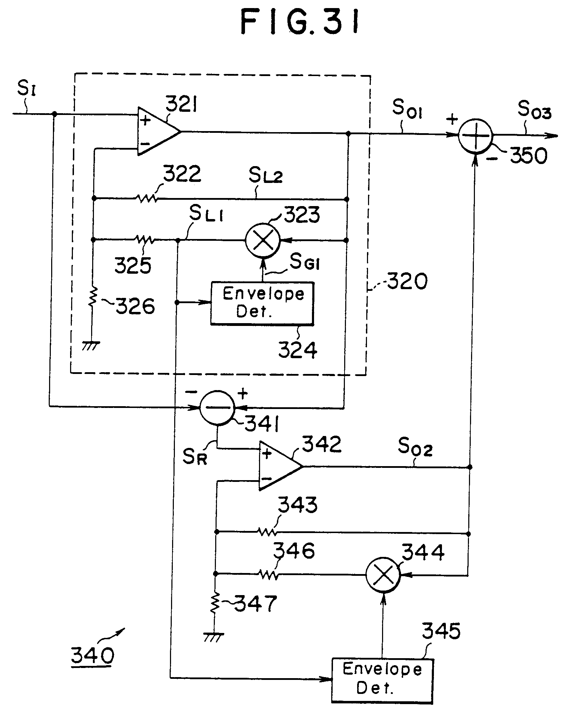

Then, referring to Fig. 31, a circuit arrangement where the circuit of Fig. 25 is employed in the preferred embodiment shown in Fig. 4 will be described.

The same reference numerals are employed for denoting the same or similar circuit elements of Fig. 25 in the circuit arrangement shown in Fig. 31. Reference numeral 340 indicates as a whole an amplitude compressing/expanding circuit. A main signal pass circuit is arranged by the circuit 320 shown in Fig. 25, and a signal sub-pass circuit is employed for this main pass circuit.

More specifically, a subtracter circuit 341 receives both the output signal S₀₁, from the operational amplifier circuit 321 and the voice signal 8₁, whereas a difference signal S_{R} is received by the non-inverting input terminal of the operational amplifier circuit 342.

The operational amplifier circuit 342, which is similar to the operational amplifier circuit 321, includes a first feedback circuit constructed of a resistor 343, and an envelope detector circuit 345 for controlling the multiplier circuit 344 and the gain of the multiplier circuit 344. The operational amplifier circuit 342 feeds back the output signal Sₒ₂ to the non-inverting input terminal via the resistors 346 and 347.

In addition, an envelope detector circuit 345 receives the output signal S_{L1} of the multiplier circuit 323 which is input into this envelope circuit 345, and in the multiplier circuit 344, the gain thereof is changed, which is similar to the multiplier circuit 323.

Furthermore, resistance values of the resistors 343, 346 and 347 are so selected in such a manner that the input/output characteristic of the operational amplifier circuit 342 is equal to the input/output characteristic of the operational amplifier circuit 321.

In contrast, the adder circuit 350 outputs the summation signal obtained from the output signals S₀₁ and Sₒ₂ of the operational amplifier circuits 321 and 342 as an output signal Sₒ₃ of the amplitude compressing/expanding circuit 340.

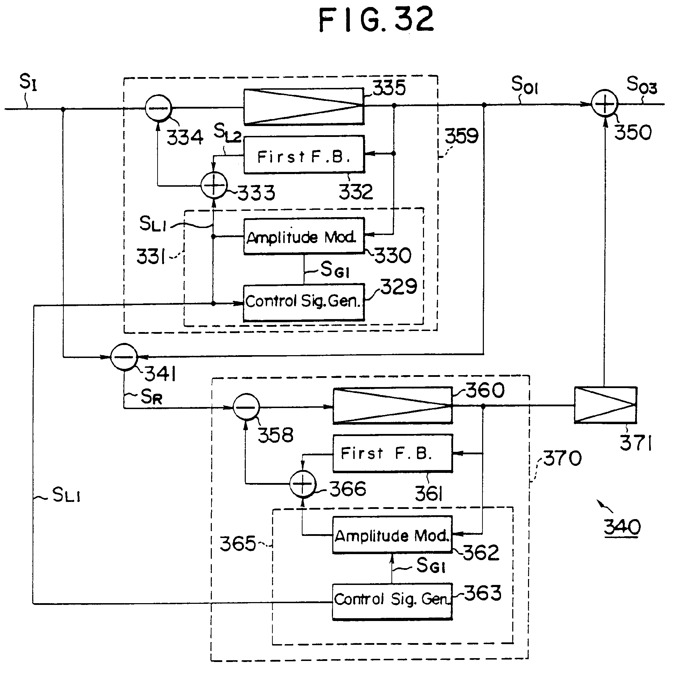

Consequently, when this circuit arrangement is expressed as an equivalent circuit as illustrated in Fig. 32 by denoting the same reference numerals to the corresponding circuit elements of Fig. 26, the circuit 320 constitutes the main pass circuit 359, whereas the operational amplifier circuit 342 constitutes the amplifier circuit 360 and subtracter circuit 358.

In addition, the resistor 343 constitutes the first feedback circuit 361, whereas the multiplier circuit 344 constitutes the amplitude modulator circuit 362 and the envelope detector circuit 345 constitutes the control signal generator circuit 363. Then, both the amplitude modulator circuit 362 and the control signal generator circuit 363 constitute the second feecback circuit 365.

Moreover, both the resistors 346 and 347 constitute the adder circuit 366. The operational amplifier circuit 342 constitutes the first and second feedback circuits, and also the sub-pass circuit 370, the gain of which is changed similar to the main pass circuit 359, in response to the input signal 8₁ and output signal S₀₁ of the main pass signal 359, and the difference signal S_{R}. The operational amplifier circuit 342 adds its output signal Sₒ₂ via the amplifier circuit 371 having a predetermined gain to the output signal S₀₁ of the main pass circuit 359, thereby outputting the summation signal.

As a consequence, since, in the control signal generator circuits 329 and 363 shown in Fig. 32, the control signal S_{G1} is produced based upon the output signal S_{L1} of the amplitude modulator circuit 330 in the main pass signal 359, the circuit arrangement shown in Fig. 32 is equivalent to the circuit which is formed by eliminating the filter circuit 23 from the circuit arrangement shown in Fig. 4 if both the main pass circuit 359 and the sub-pass circuit 370 are represented as the multiplier circuit the input/output characteristic of which is changed, as illustrated in Fig. 30, in response to the signal level of the input signal.

In other words, both the main pass circuit 359 and sub-pass circuit 370 are represented as the multiplier circuits 375 and 376, respectively. The gains of these multiplier circuits 375 and 376 are changed by means of the control signal S_{G2}, the amplitude compression ratio CR is equal to a value of 1 in the range below the threshold point, and the amplitude compression ratio CR is equal to an infinitive value in the range above the threshold point.

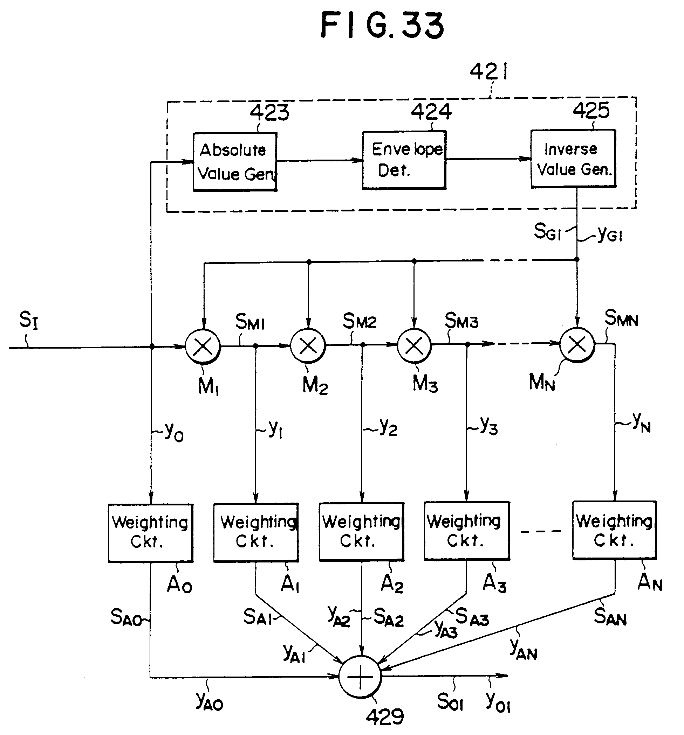

Referring now to Fig. 33, a still further preferred embodiment of the invention will be described by changing the representing method of the preferred embodiment shown in Fig. 4, and moreover expanding this circuit arrangement

In Fig. 33, reference numeral 420 represents as a whole an amplitude compressing/expanding circuit. The input signal 8₁ constructed of the digital audio signal is received by the control signal generator circuit 421 and by the multiplier circuit M₁.

The control signal generator circuit 421 is operated in such a manner that the input signal 8₁ is received via an absolute value circuit 423 arranged by a full-wave rectifier circuYit by the envelope detector circuit 424. The control signal generator circuit 421 outputs the detected signal S_{L} directly proportion to the signal level of the input signal Sₗ via a reciprocal inverting circuit 425, as a control signal S_{G1}.

As a consequence, the control signal S_{G1} having the signal level expressed by the following equation (37) by employing the proportion constant "a₁" for the amplitude x of the input signal "S"; 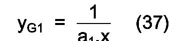 In the control signal generator circuit 421, this control signal S_{G1} is output to the N-series-connected multiplier circuits M_{1'} M₂, M₃, ..., M_{N} so as to control gains of these series-connected multiplier circuits M₁ through M_{N}.

As a result, the respetctive multiplier circuits M₁ to M_{N} perform the multiplier processing to the input signal by utilizing the coefficient x⁻¹ represented by the below-mentioned equation (38) so as to obtain outputs: 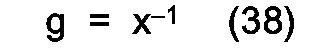 To the multiplier circuit M_{1'} the input signal Sₗ denoted by the following equation is input:
^{y}o ⁼ x (39)

Whereas from the multiplier circuit M_{1'} the multiplied signal S_{M1} is obtained which is represented by the following equation (40);

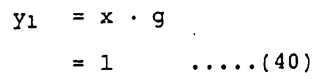

Since in addithion, the multiplied signal S_{M1} is input into the succeeding multiplier circuit M₂ so as to be multiplied therein, another multiplied signal S_{M2} denoted by the following equation (4) is obtained:

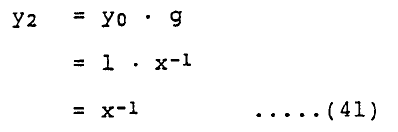

Thus, in the multiplier circuits M₁ through M_{N}, the input signal is sequentially multiplied so that the multiplier processing is carrried out by the number "N" which corresponds to the N-series connected multiplier circuits. In the respective multiplier circuits M₁ to M_{N}, the multiplier signals S_{M1}, S_{M2}, S_{M3}, ... , S_{MN} can be obtained which are represented by the following generic equation: 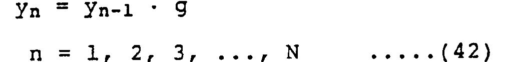 When simplifying this generic equation (42), the multiplied singals S_{M1} to S_{MN} can be produced which are expressed by the following equation:

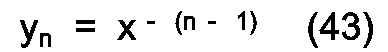

In addition, the amplitude compressing/expanding circuit 420 includes (N+1) weighting circuits Aₒ, A_{1'} A₂, A3, ... AN which are arranged by amplifier circuits, outputs the input signal S_{I} and the respective multiplier signals S_{M1}, S_{M2}, S_{M3}, ..., S_{MN} via the respective weighting circuits Aₒ to AN to the adder circuit 429. Moreover, the amplitude compressing/expanding circuit 420 weights both the input signal S₁ and the respective multiplied signals S_{M1} to S_{MN} by way of the weighting coefficients determined by the gains of the respective weighting circuits Aₒ to AN, and outputs its summation signals as an output signal Sₒₗ.

As a consequence, if the weighting coefficients of the respective weighting circuits Aₒ toA_{N} are expressed by the respective values Cₒ, C₁, C₂, C₃, ..., C_{N}, the output signal S_{A0} can be obtained via the weighting circuit Aₒ based upon the above-described equation (39), which is expressed by the following equation :

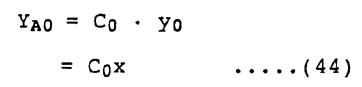

In contrast, in the remaining weighting circuits A_{1'} to AN, the output signals S_{A1}, S_{A2}, S_{A3}, ..., S_{AN} can be produced from the above-described equation (43), which is represented by the following generic equation:

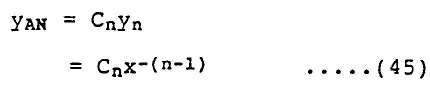

As a consequence, the output signal S₀₁ can be obtained via the adder circuit 429 from the previous equations (44) and (45), which is represented by the following equation:

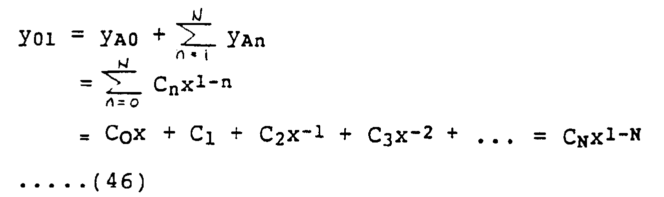

Accordingly, since the weighting coefficients Cₒ to C_{N} of the weighting circuits Aₒ to AN are set to the desired values, the input/output characteristics expressed by the higher order function formula of the equation (46) can be achieved, and therefore, the input/output characteristic where the amplitude compression ratio is smoothly and complexly varied withe the simpler circuit arrangement.

In the practical case, when both the weighting coefficients Cₒ and C₁ of the weighting circuits Aₒ and A₁ are set to a value of 1, and the weighting coefficients C₂ to C_{N} of the weighting circuits A₂ to AN are set to a value of 0, the output signal S₀₁ can be produced which is represented by the following relation equation (47) from the previous equation (46):

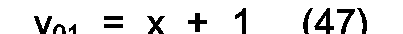

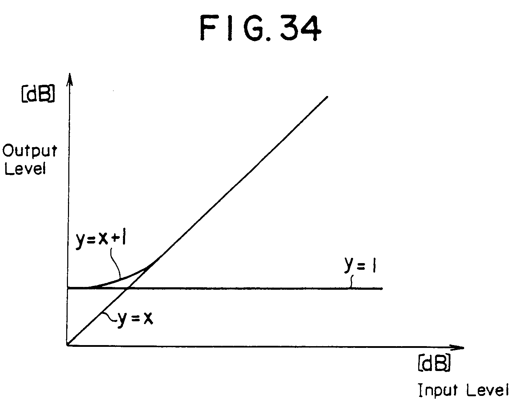

In this case, as illustrated in Fig. 34, with respect to the input/output characteristic where the amplitude compression ratio CR is equal to both the infinitive and the value of 1, which is represented by the following relationships: 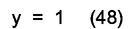 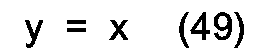 the amplitude compressing/expanding circuit having the input/output characteristic can be obtained, where the amplitude compression ratio is smoothly changed from the infinitive to the value of 1 at the threshold point corresponding to the input level at which the first-mentioned input/output characteristic is intercepted. The input/output characteristic of the amplitude compressing/expanding circuit is expressed by the following equations:

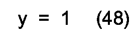

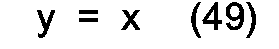

With the above-described circuit arrangement, the control signal S_{G1} is obtained from the control signal generator circuit 421 based upon the input signal level of the input signal S_{I}, and the series-connected multiplier circuits M₁ to M_{N} perform the multiplying process on the input signal S_{I} with the coefficient x⁻¹, based upon this control signal.

As a result, the multiplied signals S_{M1} to S_{MN} are obtained from the multiplier circuits M₁ to M_{N} which represent the respective terms of the (N-1) order function formula with respect to the amplitude "X" of the input signal S_{I}. These multiplied signals are summed withe the input signal S_{I} via the predetermined weighting coefficients Cₒ to C_{N} of the weighting circuits Aₒ to AN and then output, so that the input/output characteristic represented by the (N-1) higher order function formula can be obtained.

With the above-described circuit arrangement, the multiplier circuits are series-connected to each other, and the multiplied outputs are added to the predetermined coefficients so as to be output, with the result that the input/output characteristic represented by the higher order function formula with respect to the amplitude of the input signal can be obtained. As a consequence, the amplitude compressing/expanding circuit having the input/output characteristic can be obtained with the simpler circuit arrangement, in which the amplitude compression ratio is smoothly and complexly changed.

## Claims

1. An amplitude expanding and/or compressing circuit (20) for expanding and/or compressing an amplitude of an input signal (S_{I}) comprising:
control signal generating means (4) supplied with the input signal (S_{I}) and for generating a control signal (So);
signal multiplier means (3) for multiplying the control signal (S_{G}) to said input signal (S_{I}) and for generating a multiplied output (So);
characterized by
first substracter means (21) for substracting said input signal (S_{I}) from said multiplied output (So);
signal processing means (26) including a second signal multiplier means (22) for multiplying said control signal (S_{G}) with the output (S_{R}) of said first substracter means and for generating a processed output (Sₛ); and
second substracter means (25) for substracting said processed output (Sₛ)from said multiplied output (So), whereby the amplitude expanded and/or compressed output signal (So)is obtained at its output.

2. An amplitude expanding and/or compressing circuit according to claim 1, wherein said signal processing means (26) further includes amplifier means (24) supplied with the output of said second multiplier means (22), and the output (Sₛ) of said amplifier means (24) is supplied to said second substracter means (25).

3. An amplitude expanding and/or compressing circuit according to claim 1, wherein said signal processing means (26) includes filter means (23) supplied with the output (S_{R}) of said first substracter means (21).

4. An amplitude expanding and/or compressing circuit according to claim 3, wherein said filter means (23) includes a low-pass-filter.

5. An amplitude expanding and/or compressing circuit according to claim 1, wherein said control signal generating means (4) includes an absolute value generating means (5) supplied with said input signal (S), envelope detector means (6) for detecting the envelope of the output of said absolute value generating means (5), plural stages of signal multipliers (M₁, M₂...), a first stage (Mᵢ) of which is supplied with the output of said envelope detector means (6) to two input terminals thereof, the remaining stages (M₂, M₃...) of which are supplied with outputs (S_{M1}, S_{M2}...) of preceding stages and the output of said envelope detector means, respectively, weighting circuits (Aₒ,A₁...), each of which multiplies predetermined coefficients to the input of each said plural stages of signal multipliers, an adder means (229) for adding the outputs of said weighting circuits together.

6. An amplitude expanding and/or compressing circuit according to claim 1, wherein said control signal generating means and said signal multiplier means includes an operational amplifier (321) having first and second feed-back circuits (322, 323...), said first feed-back circuit including a voltage divider (322, 326) for dividing the output of said operational amplifier and voltage divided signal being fed to an input to said operational amplifier, said second feed-back circuit includes a multiplier (323) supplied with the output (X_{I}) of said operational amplifier and the output (S_{G1}) of said envelope detector (324) for detecting the envelope of the output of said multiplier, and the output of said multiplier (323) being fed to the input of said operational amplifier (321).

7. An amplitude expanding and/or compressing circuit according to claim 1, wherein said control signal generating circuit (421) includes an absolute value generating means (423), envelope detector means (424) for detecting the envelope of the output of said absolute value generating means, and inverse value generating means (425) for generating the inverse value of the output of said envelope detector means, said inverse value of generating means includes floating point arithmetic processing means, and said envelope detector means includes detecting portion and normalizing portion having pre-bit-shifting means for bit-shifting the envelope detected data by an amount determined by a control signal, normalizing means supplied with the output of said pre-bit-shifting means and for bit-shifting the same such that a normalized output signal is generated, said normalizing means further generating bit shift signal representing the bit shift amount required for normalizing the sample data one sample prior to the current sample data applied to said pre-bit-shifting means, and control means supplied with said bit shift signal and generating said control signal supplied to said pre-bit-shift means.

8. An amplitude expanding and/or compressing circuit according to claim 7, wherein said detecting portion of said envelope detector means (111) includes a subtracter (113) supplied with the output of said absolute value generating means (5), a mode detector (118) for detecting the polarity of the output of said subtracter, a first multiplier (115) for multiplying the output of said mode detector to the output of said subtracter, an adder (117) for generating said envelope detected output (52), a one sample delay circuit (114) supplied with said envelope detected output and for delaying the same for one sample duration, the output of said one sample delay circuit being supplied to said subtracter, and a second multiplier (116) for multiplying a predetermined coefficient (SR) to the output of said one sample delay circuit and generating an output supplied to said adder.

## Patentansprüche

1. Dynamikexpansions- und/oder Kompressionsschaltung (20) zum Expandieren und/oder Komprimieren der Amplitude eines Eingangssignals (S_{I}) mit:
- einer steuersignal-Erzeugungsschaltung (4) , die mit dem Eingangssignal (S_{I}) versorgt wird und ein Steuersignal (S_{G}) abgibt;
- einer Signalmultipliziereinrichtung (3) zum Multiplizieren des Steuersignals (S_{G}) mit dem Eingangssignal (S_{I}) und zum Erzeugen eines Multiplikationsausgangssignals (Sₒ);
gekennzeichnet durch
- eine erste Subtrahiereinrichtung (21) zum Subtrahieren des Eingangssignals (S_{I}) vom Multiplikationsausgangssignal (Sₒ);
- eine Signalverarbeitungseinrichtung (26) mit einer zweiten Signalmultipliziereinrichtung (22) zum Multiplizieren des Steuersignals (S_{G}) mit dem Ausgangssignal (S_{R}) der ersten Subtrahiereinrichtung und zum Erzeugen eines verarbeiteten Ausgangssignals (Sₛ); und
- eine zweite Subtrahiereinrichtunq (25) zum Subtrahieren des verarbeiteten Ausgangssignals (Sₛ) vom Multiplikationsausgangssignal (Sₒ), wodurch an ihrem Ausgang ein Ausgangssignal (S₀₁) mit expandierter und/oder komprimierter Amplitude erhalten wird.

2. Amplitudenexpansions- und/oder Kompressionsschaltung nach Anspruch 1, bei der die Signalverarbeitungseinrichtung (26) ferner eine Verstärkungseinrichtung (24) aufweist, die mit dem Ausgangssignal der zweiten Multipliziereinrichtung (22) versorgt wird, wobei das Ausgangssignal (Sₛ) der Verstärkungseinrichtung (24) der zweiten Subtrahiereinrichtung (25) zugeführt wird.

3. Amplitudenexpansions- und/oder Kompressionsschaltung nach Anspruch 1, bei der die Signalverarbeitungseinrichtung (26) eine Filtereinrichtung (23) aufweist, die mit dem Ausgangssignal (S_{R}) der ersten Subtrahiereinrichtung (21) versorgt wird.

4. Amplitudenexpansions- und/oder Kompressionsschaltung nach Anspruch 3, bei der die Filtereinrichtung (23) ein Tiefpaßfilter aufweist.

5. Amplitudenexpansions- und/oder Kompressionsschaltung nach Anspruch 1, bei der die Steuersignal-Erzeugungsschaltung (4) folgendes aufweist: eine Absolutwert-Erzeugungsschaltung (5), die mit dem Eingangssignal (S_{I}) versorgt wird; eine Einhüllendendetektoreinrichtung (6) zum Erkennen der Einhüllenden des Ausgangssignals derAbsolutwert-Erzeugungseinrichtung (5); mehrere Stufen von Signalmultiplizierern (M₁, M2,...), von denen eine erste Stufe (M₁) mit dem Ausgangssignal der Einhüllendendetektoreinrichtung (6) an zweien ihrer Eingangsanschlüsse versorgt wird, wobei die restlichen Stufen (M₂, M₃, ...) derselben jeweils mit den Ausgangssignalen (S_{M1}, S_{M2}, ...) vorangehender Stufen und mit dem Ausgangssignal der Einhüllendendetektoreinrichtung versorgt werden; Gewichtungsschaltungen (Aₒ, A_{1'} ...), von denen jede vorgegebene Koeffizienten mit dem Eingangssignal jeder der mehreren Stufen von Signalmultiplizierern multipliziert; und eine Addiereinrichtung (229) zum Addieren der Ausgangssignale der Gewichtungsschaltungen miteinander.

6. Amplitudenexpansions- und/oder Kompressionsschaltung nach Anspruch 1, bei der die Steuersignal-Erzeugungseinrichtung und die Signalmultipliziereinrichtung einen Operationsverstärker (321) mit einem ersten und einem zweiten Rückkopplungskreis (322, 323,...) aufweist, wobei der erste Rückkopplungskreis einen Spannungsteiler (322, 326) zum Teilen des Ausgangssignals des Operationsverstärkers aufweist, und wobei das spannungsgeteilte Signal einem Eingang des Operationsverstärkers zugeführt wird, und wobei der zweite Rückkopplungskreis einen Multiplizierer (323) aufweist, der mit dem Ausgangssignal (X_{I}) des zweiten Operationsverstärkers und dem Ausgangssignal (S_{G1}) des Einhüllendendetektors (324) zum Erfassen der Einhüllenden des Ausgangs des Multiplizierers versorgt wird, und wobei das Ausgangssignal des Multiplizierers (323) dem Eingang des Operationsverstärkers (321) zugeführt wird.

7. Amplitudenexpansions- und/oder Kompressionsschaltung nach Anspruch 1, bei der die Steuersignal-Erzeugungsschaltung (421) folgendes aufweist: eine Absolutwert-Erzeugungseinrichtung (423); eine Einhüllendendetektoreinrichtung (424) zum Erfassen der Einhüllenden des Ausgangssignals derAbsolutwert-Erzeugungseinrichtung; und eine Kehrwert-Erzeugungseinrichtung (425) zum Erzeugen des Kehrwerts des Ausgangssignals der Einhüllendendetektoreinrichtung, wobei die Kehrwert-Erzeugungseinrichtung eine Gleit-, Arithmetikverarbeitungsschaltung aufweist, und wobei die Einhüllendendetektoreinrichtung einen Meßabschnitt und einen Normierungsabschnitt aufweist, der über eine Bit-Vorverschiebeeinrichtung zur Bitverschiebung der Einhüllendenmeßdaten um ein Ausmaß, das von einem Steuersignal festgelegt wird, und eine Normierungseinrichtung verfügt, die mit dem Ausgangssignal der Bit-Vorverschiebeeinrichtung versorgt wird, um eine Bitverschiebung desselben in solcher Weise vorzunehmen, daß ein normiertes Ausgangssignal erzeugt wird, wobei die Normierungseinrichtung ferner ein Bitverschiebungssignal erzeugt, das das Bitverschiebungsausmaß repräsentiert, das zum Normieren der Probendaten für eine Probe vor den aktuellen Probendaten erforderlich ist, wie sie der Bit-Vorverschiebeeinrichtung zugeführt werden, und eine Steuereinrichtung, die mit dem Bitverschiebungssignal versorgt wird und die das Steuersignal erzeugt, das der Bit-Vorverschiebeeinrichtung zugeführt wird.

8. Amplitudenexpansions- und/oder Kompressionsschaltung nach Anspruch 7, bei der der Meßabschnitt der Einhüllendendetektoreinrichtung (111) folgendes aufweist: einen Subtrahierer (113), der mit dem Ausgangssignal der Absolutwert-Erzeugungseinrichtung (5) versorgt wird; einen Modusdetektor (118) zum Erfassen der Polarität des Ausgangssignals des Subtrahierers; einen ersten Multiplizierer (115) zum Multiplizieren des Ausgangssignals des Modusdetektors mit dem Ausgangssignal des Subtrahierers; einen Addierer (117) zum Erzeugen des Einhüllendenmeßausgangssignals (52); eine 1-Probe-Verzögerungsschaltung (114), die mit dem Einhüllendenmeßausgangssignal versorgt wird, um dasselbe um die Dauer einer Probe zu verzögern, wobei das Ausgangssignal der 1-Probe-Verzögerungsschaltung dem Subtrahierer zugeführt wird; und einen zweiten Multiplizierer (116) zum Multiplizieren eines vorgegebenen Koeffizienten (SR) mit dem Ausgangssignal der 1-Probe-Verzögerungsschaltung und zum Erzeugen eines dem Addierer zugeführten Ausgangssignals.

## Revendications

1. Circuit de dilatation et/ou de compression d'amplitude (20) pour dilater et/ou comprimer une amplitude d'un signal d'entrée (SI) comprenant :
un moyen de génération de signal de commande (4) qui se voit appliquer le signal d'entrée (SI) et pour générer un signal de commande (S_{G}) ;
un moyen de multiplieur de signal (3) pour multiplier le signal de commande (S_{G}) par ledit signal d'entrée (SI) et pour générer une sortie multipliée (Sₒ),
caractérisé par :
un premier moyen de soustracteur (21) pour soustraire ledit signal d'entrée (SI) de ladite sortie multipliée (So);
un moyen de traitement de signal (26) incluant un second moyen de multiplieur (22) pour multiplier ledit signal de commande (S_{G}) par la sortie (S_{R}) dudit premier moyen de soustracteur et pour générer une sortie traitée (Sₛ) ; et
un second moyen de soustracteur (25) pour soustraire ladite sortie traitée (Sₛ) de ladite sortie multipliée (Sₒ) et ainsi, le signal de sortie dilaté et/ou comprimé en amplitude (S_{OI}) est obtenu au niveau de sa sortie.

2. Circuit de dilatation et/ou de compression d'amplitude selon la revendication 1, dans lequel ledit moyen de traitement de signal (26) inclut en outre un moyen d'amplificateur (24) qui se voit appliquer la sortie dudit second moyen de multiplieur (22) et la sortie (Sₛ) dudit moyen d'amplificateur (24) est appliquée audit second moyen de soustracteur (25).

3. Circuit de dilatation et/ou de compression d'amplitude selon la revendication 1, dans lequel ledit moyen de traitement de signal (26) inclut un moyen de filtre (23) qui se voit appliquer la sortie (S_{R}) dudit premier moyen de soustracteur (21).

4. Circuit de dilatation et/ou de compression d'amplitude selon la revendication 3, dans lequel ledit moyen de filtre (23) inclut un filtre passe-bas.

5. Circuit de dilatation et/ou de compression d'amplitude selon la revendication 1, dans lequel ledit moyen de génération de signal de commande (4) inclut un moyen de génération de valeur absolue (5) qui se voit appliquer ledit signal d'entrée (SI), un moyen de détecteur d'enveloppe (6) pour détecter l'enveloppe de la sortie dudit moyen de génération de valeur absolue (5), plusieurs étages de multiplieurs de signal (M₁, M2...) dont un premier étage (M₁) se voit appliquer la sortie dudit moyen de détecteur d'enveloppe (6) sur ses deux bornes d'entrée, dont les étages restants (M₂, M₃...) se voient respectivement appliquer des sorties (S_{Mi}, S_{M2} ...) d'étages précédents et la sortie dudit moyen de détecteur d'enveloppe, des circuits de pondération (Aₒ, A₁ ...) dont chacun multiplie des coefficients prédéterminés par l'entrée de chacun desdits plusieurs étages de multiplieurs de signal et un moyen d'additionneur (229) pour additionner les sorties desdits circuits de pondération ensemble.

6. Circuit de dilatation et/ou de compression d'amplitude selon la revendication 1, dans lequel ledit moyen de génération de signal de commande et ledit moyen de multiplieur de signal incluent un amplificateur opérationnel (321) comportant des premier et second circuits de retour (322,323, ...), ledit premier circuit de retour incluant un diviseur de tension (322, 326) pour diviser la sortie dudit amplificateur opérationnel et un signal divisé en tension étant appliqué sur l'entrée dudit amplificateur opérationnel, ledit second circuit de retour incluant un multiplieur (323) qui se voit appliquer la sortie (X_{I}) dudit amplificateur opérationnel et la sortie (S_{G1}) dudit détecteur d'enveloppe (324) pour détecter l'enveloppe de la sortie dudit multiplieur et la sortie dudit multiplieur (323) étant appliquée sur l'entrée dudit amplificateur opérationnel (321).

7. Circuit de dilatation et/ou de compression d'amplitude selon la revendication 1, dans lequel ledit circuit de génération de signal de commande (421) inclut un moyen de génération de valeur absolue (423), un moyen de détecteur d'enveloppe (424) pour détecter l'enveloppe de la sortie dudit moyen de génération de valeur absolue et un moyen de génération de valeur inverse (425) pour générer la valeur inverse de la sortie dudit moyen de détecteur d'enveloppe, ledit moyen de génération de valeur inverse incluant un moyen de traitement arithmétique à virgule flottante et ledit moyen de détecteur d'enveloppe incluant une partie de détection et une partie de normalisation comportant un moyen de décalage de pré-bit pour décaler binairement les données d'enveloppe détectées d'une valeur prédéterminée par un signal de commande, un moyen de normalisation qui se voit appliquer la sortie dudit moyen de décalage de pré-bit et pour décaler binairement celle-ci de telle sorte qu'un signal de sortie normalisé soit généré, ledit moyen de normalisation générant en outre un signal de décalage de bit représentant la valeur de décalage de bit requise pour normaliser les données d'échantillon un échantillon avant les données d'échantillon courantes appliquées audit moyen de décalage de pré-bit, et un moyen de commande qui se voit appliquer ledit signal de décalage de bit et qui génère ledit signal de commande appliqué audit moyen de décalage de pré-bit.

8. Circuit de dilatation et/ou de compression d'amplitude selon la revendication 7, dans lequel ladite partie de détection dudit moyen de détecteur d'enveloppe (111) inclut un soustracteur (113) qui se voit appliquer la sortie dudit moyen de génération de valeur absolue (5), un détecteur de mode (118) pour détecter la polarité de la sortie dudit soustracteur, un premier multiplieur (115) pour multiplier la sortie dudit détecteur de mode par la sortie dudit soustracteur, un additionneur (117) pour générer ladite sortie détectée d'enveloppe (52), un circuit de retard d'un échantillon (114) qui se voit appliquer ladite sortie détectée d'enveloppe et pour retarder celle-ci d'une durée d'un échantillon, la sortie dudit circuit de retard d'un échantillon étant appliquée audit soustracteur, et un second multiplieur (116) pour multiplier un coefficient prédéterminé (SR) par la sortie dudit circuit de retard d'un échantillon et pour générer une sortie appliquée audit additionneur.
